# EUROPEAN PATENT SPECIFICATION

(11) **EP 3 438 960 B1**
(45) Date of publication and mention of the grant of the patent: **06.09.2023**
(21) Application number: 18187383.7
(22) Date of filing: 03.08.2018
(51) Int. Cl.: G09G 3/3233, G09G 3/3266, G09G 3/3291

(54) **ORGANIC LIGHT EMITTING DISPLAY DEVICE**
ORGANISCHE LICHTEMITTIERENDE ANZEIGEVORRICHTUNG
AFFICHEUR ÉLECTROLUMINESCENT ORGANIQUE

(30) Priority: 03.08.2017 KR 20170098728
(43) Date of publication of application: 06.02.2019
(73) Proprietor: Samsung Display Co., Ltd., Gyeonggi-do (KR)
(72) Inventor: YANG, Jin-Wook, Gyeonggi-do (KR); KIM, Soon-Dong, Gyeonggi-do (KR)
(74) Representative: Marks & Clerk LLP

(56) References cited:
- US-A1- 2014 035 974

## Description

### BACKGROUND

### 1. Technical Field

Example embodiments of the inventive concept relate to a display device. More particularly, example embodiments of the inventive concept relate to an organic light emitting display device capable of compensating a threshold voltage of a driving transistor.

### 2. Description of the Related Art

The display device displays an image based on light emitted by pixels. An organic light emitting display device includes pixels each having an organic light emitting diode (OLED). The organic light emitting display device includes a structure for compensating a threshold voltage of a driving transistor and initializing an anode of the OLED in the pixel to improve display quality by compensating luminance deviation between the pixels.

To solve problems caused by increasing a resolution of the organic light emitting display device such as increasing wirings included in the display panel, the output of the data driver can be controlled by a demultiplexer. For example, the demultiplexer supports that the data writing period is time-shared (e.g., time-divided into N: 1) between adjacent data lines to reduce wirings in the display panel and output channels of the data driver, where N is an integer greater than 1.

However, in the high resolution display device, the compensating period of the threshold voltage of the driving transistor may be significantly reduced since the data signal is switched quickly by the demultiplexer. Therefore, the compensating period may not be secured sufficiently, and then display defects such as spots in the displayed image may be recognized.
US2014/035974 describes a display unit that includes pixel circuits disposed in a matrix form of rows and columns and a drive control section that causes the pixel circuits to display image frames of input image data such that a single frame of the image frames is displayed in two parts as a first sub-frame and as a second sub-frame. The first and second sub-frames are displayed field sequentially by different portions of the pixel circuits. The first sub-frame is displayed by a first portion of the pixel circuits that are located in a checked pattern, while the second sub-frame is displayed by the remaining pixel circuits.

### SUMMARY

Example embodiments seek to provide an organic light emitting display device capable of compensating a threshold voltage of a driving transistor by applying odd-numbered group gate signal and even-numbered group gate signal to each pixel row.

Example embodiments seek to provide an organic light emitting display device capable of being driven at a high frequency and sufficiently securing a threshold voltage compensation period for each sub-pixel.

According to some example embodiments, there is provided an organic light emitting display device according to claim 1.

Optional features of the embodiments are provided in dependent claims 2 to 8.

Therefore, an organic light emitting display device according to example embodiments commonly provides the emission control signal and the initialization signal to each pixel row, and separately provides an odd-numbered group gate signal to odd-numbered pixel groups and an even-numbered group gate signal to even-numbered pixel groups as the gate signal. The odd-numbered group gate signal overlaps at least a part of the even-numbered group gate signal. Accordingly, the compensation time for compensating the threshold voltage of the driving transistor can be sufficiently secured, thereby preventing display defects such as spots in displayed image and improving the display quality of a high resolution display device or a display device driven using demultiplexers.

In addition, odd-numbered group gate lines and even-numbered group gate lines are disposed at opposite positions on neighboring pixel rows, thereby preventing image deviations.

At least some of the above features that accord with the invention, and other features according to the invention, are set out in the claims.

### BRIEF DESCRIPTION OF THE DRAWINGS

Embodiments of the invention will be described more fully hereinafter with reference to the accompanying drawings, in which various embodiments are shown.
FIG. 1 is a block diagram illustrating an organic light emitting display device according to example embodiments.
FIG. 2 is a circuit diagram illustrating an example of a display panel included in the organic light emitting display device of FIG. 1.
FIG. 3 is a circuit diagram illustrating an example of a sub-pixel included in the display panel of FIG. 2.
FIG. 4 is a timing diagram illustrating an example in which the sub-pixel of FIG. 3 is driven in a compensation period.
FIG. 5 is a timing diagram illustrating one example of signals for driving the display panel of FIG. 2.
FIG. 6 is a diagram for describing operations of pixel groups in the compensation period according to the timing diagram of FIG. 5.
FIG. 7 is a timing diagram illustrating another example of signals for driving the display panel of FIG. 2.
FIG. 8 is a diagram illustrating an example of an arrangement in which first group gate lines and second group gate lines are connected to pixel groups in the display panel of FIG. 2.
FIG. 9 is a diagram schematically illustrating an example of pixel groups included in the display panel of FIG. 2.
FIG. 10 is a diagram schematically illustrating an example of data lines connected to the display panel of FIG. 2.
FIG. 11 is a circuit diagram illustrating an example of an arrangement of the data lines of FIG. 10.
FIG. 12 is a diagram illustrating an example of a first group gate signal and a second group gate signal generated by the organic light emitting display device of FIG. 1.
FIG. 13 is a diagram schematically illustrating a display panel included in the organic light emitting display device according to example not forming part of an embodiment.
FIG. 14 is a diagram schematically illustrating an example of gate signals and data signals provided to the display panel of FIG. 13.
FIG. 15 is a timing diagram illustrating an example of signals for driving the display panel of FIG. 14.
FIG. 16A is a diagram for describing an example in which a threshold voltage of a driving transistor is compensated in the display panel of FIG. 14.
FIGS. 16B, 16C, and 16D are diagrams for describing examples in which a threshold voltage of a driving transistor is compensated in the display panel of FIG. 14.
FIG. 17 is a diagram illustrating an example of a display panel included in an organic light emitting display device not forming part of an embodiment.
FIG. 18 is a diagram illustrating an example of a display panel included in the organic light emitting display device of FIG. 17.
FIG. 19 is a timing diagram illustrating an example of signals for driving the display panel of FIG. 18.

### DESCRIPTION OF EMBODIMENTS

Embodiments of the invention will be described more fully hereinafter with reference to the accompanying drawings, in which various embodiments are shown.

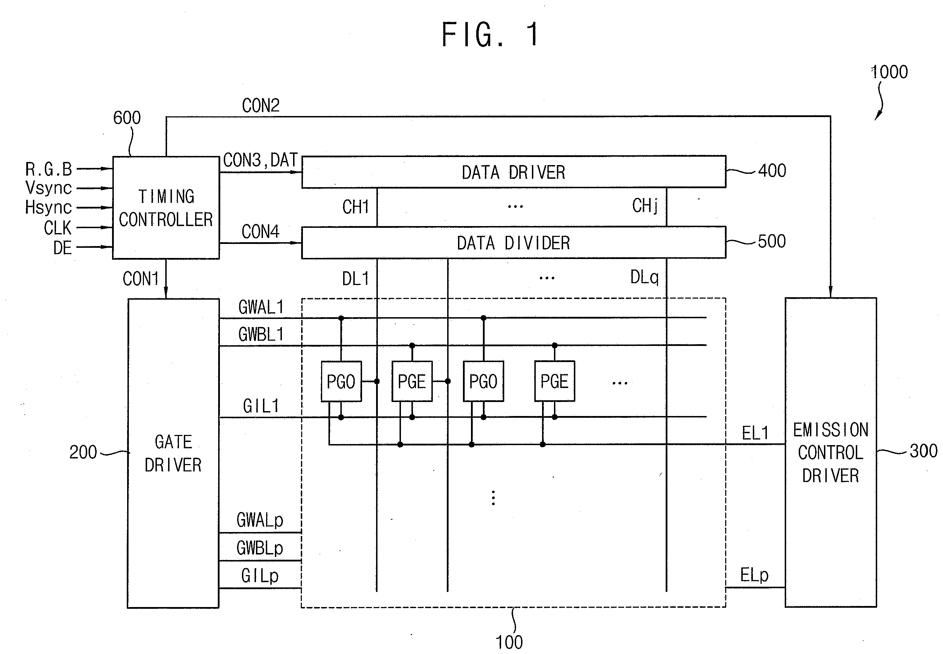

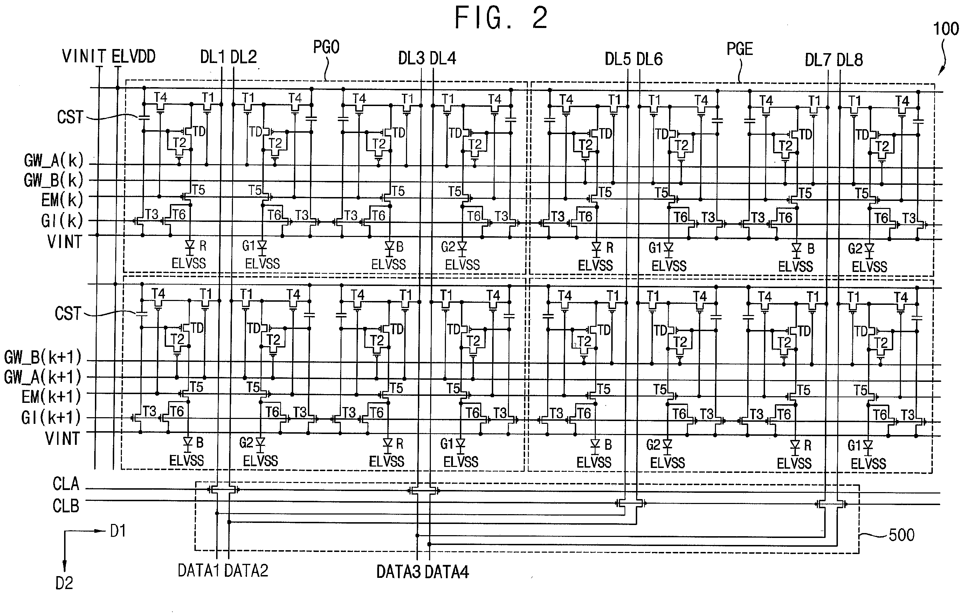

FIG. 1 is a block diagram illustrating an organic light emitting display device 1000 according to example embodiments. FIG. 2 is a circuit diagram illustrating an example of a display panel 100 included in the organic light emitting display device 1000 of FIG. 1.

Referring to FIGS. 1 and 2, the organic light emitting display device 1000 includes the display panel 100, a gate driver 200, an emission control driver 300, a data driver 400, and a data divider 500. The organic light emitting display device 1000 may include a timing controller 600.

The organic light emitting display device 1000 may be a flat display device, a flexible display device, a curved display device, a foldable display device, or a bendable display device. Further, the organic light emitting display device 1000 can be applied to a transparent display device, a head-mounted display device, a wearable display device, etc.

The display panel 100 includes a plurality of pixel rows. Each of the pixel rows includes a plurality of pixel groups PGO, PGE. Each of the pixel groups PGO, PGE includes a plurality of sub-pixels. The sub-pixels may be arranged in a matrix form of p rows * q columns, where p and q represent integers greater than 1. Each of the sub-pixels receives a gate signal, an initialization signal, an emission control signal, and a data signal to be driven.

In one example embodiment, the pixel groups PGO, PGE included in single pixel row are divided into a first pixel group and a second pixel group. For example, the first pixel group is defined as an odd-numbered pixel group PGO, and the second pixel group is defined as an even-numbered pixel group PGE. However, the manner of distinguishing the pixel groups is not limited thereto. For example, some of the first pixel groups (or some of the second pixel groups) may be arranged continuously. In one example, the first number of the first pixel groups in single pixel row may be equal to the second number of the second pixel groups in single pixel row. In another example, the first number of the first pixel groups in single pixel row may be different from the second number of the second pixel groups in single pixel row.

Hereinafter, it is assumed that the first pixel group is the odd-numbered pixel group PGO and the second pixel group is the even-numbered pixel group PGE.

Each of the odd-numbered pixel group PGO and the even-numbered pixel group PGE may include four sub-pixels. For example, each of the pixel groups PGO, PGE may include a red sub-pixel, a blue sub-pixel, and two green sub-pixels. However, the number of sub-pixels included in each of the pixel groups PGO, PGE is not limited thereto.

In addition, as shown in FIGS. 1 and 2, the odd-numbered pixel groups PGO are connected to the first group gate lines (e.g., odd-numbered group gate lines GWAL1 to GWALp). Also, the even-numbered pixel groups PGE are connected to the second group gate lines (e.g., even-numbered group gate lines GWBL1 to GWBLp). In other words, the sub-pixels connected to the odd-numbered group gate lines GWAL1 to GWALp, which are the first group gate lines, are defined as the odd-numbered pixel group PGO. Also, the sub-pixels connected to the even-numbered group gate lines GWBL1 to GWBLp, which are the second group gate lines, are defined as the even-numbered pixel group PGE.

Each of the sub-pixels may include a driving transistor TD and a plurality of switch transistors T1, T2, T3, T4, T5, and T6. Each of the sub-pixels are connected to one of the odd-numbered group gate lines GWAL1 to GWALp or one of even-numbered group gate lines GWBL1 to GWBLp.

The timing controller 600 may receive image data R.G.B, a vertical synchronization signal Vsync, a horizontal synchronization signal Hsync, a main clock signal CLK, and a data enable signal DE, etc. The timing controller 600 may generate a gate driver control signal CON1, an emission driver control signal CON2, a data driver control signal CON3, a data divider control signal CON4, and output image data DAT corresponding the image data R.G.B based on above signals. The timing controller 600 may provide the gate driver control signal CON1 to the gate driver 200, provide the output image data DAT and the data driver control signal CON3 to the data driver 400, provide the emission driver control signal CON2 to the emission control driver 300, and provide the data divider control signal CON4 to the data divider 500.

The gate driver 200 sequentially provides the initialization signal to initialization lines GIL1 to GILp, which may be based on the gate driver control signal CON1 provided from the timing controller 600. Each of the initialization lines GIL1 to GILp is connected to the pixel rows respectively. As shown in FIG. 2, the (k)th initialization line transferring the (k)th initialization signal GI(k) may be connected to entire sub-pixels of the (k)th pixel row, where k is a positive integer less than or equal to p.

In addition, the gate driver 200 sequentially provides the first group gate signal to the first group gate lines and sequentially provides the second group gate signal to the second group gate lines, which may be based on the gate driver control signal CON1. In one example embodiment, when the first group gate lines correspond to odd-numbered group gate lines GWAL1 to GWALp, the first group gate signal corresponds to an odd-numbered group gate signal. When the second group gate lines correspond to even-numbered group gate lines GWBL1 to GWBLp, the second group gate signal corresponds to an even-numbered group gate signal. Here, the odd-numbered group gate signal and the even-numbered group gate signal that are applied to the same pixel row partially overlap each other.

In one example embodiment, the even-numbered group gate signal may be delayed by 1/2 horizontal period from the odd-numbered group gate signal. In another example embodiment, the odd-numbered group gate signal may be delayed by 1/2 horizontal period from the even-numbered group gate signal.

As shown in FIG. 2, the (k)th odd-numbered group gate line transferring the (k)th odd-numbered group gate signal GW_A(k) may be connected to the odd-numbered pixel group PGO of the (k)th pixel row. Also, the (k)th even-numbered group gate line transferring the (k)th even-numbered group gate signal GW_B(k) may be connected to the even-numbered pixel group PGE of the (k)th pixel row.

The emission control driver 300 may sequentially provide the emission control signal to emission control lines EL1 to ELp, which may be based on the emission driver control signal CON2. Each of the emission control lines EL1 to ELp is connected to the pixel rows respectively. As shown in FIG. 2, the (k)th emission control line transferring the (k)th emission control signal EM(k) may be connected to the entire sub-pixels of the (k)th pixel row.

The data driver 400 provides the data signal (or data voltage) to a plurality of output lines CH1 to CHj, which may be based on the data driver control signal CON3 and the output image data DAT provided from the timing controller 600, where j is a positive integer smaller than q.

The data divider 500 selectively provides the data voltage to data lines DL1 to DLq connected to the sub-pixels, which may be based on the data divider control signal CON4 such that a single output line is time-shared by some of the data lines. In one example embodiment, the data divider 500 may include a plurality of demultiplexers. For example, each demultiplexer may transfer the data voltage from one output line to one of N data lines through N switches (e.g., switch transistors), where N is an integer between 2 and 6. Thus, the organic light emitting display device 1000 may provide the data voltages to the sub-pixels by the demultiplexers (hereinafter, referred to as the DEMUX driving manner).

As shown in FIG. 2, the data divider 500 includes a plurality of switch transistors connected to the data lines DL1 to DL8 and receive data voltages DATA1 to DATA4 from the data driver 400 (e.g., latches of the data driver 400). The switch transistors included in the data divider 500 are controlled by the clock signals CLA and CLB of which phase have a half period difference (e.g., have opposite phases to each other). For example, when the first clock signal CLA has an activation level (or turn-on level), the data voltages may be provided to the first to fourth data lines DL1 to DL4 and data voltage is applied (or written) to the sub-pixels of the odd-numbered pixel group PGO. When the second clock signal CLB has the activation level, the data voltages may be provided to the fifth to eighth data lines DL5 to DL8 and data voltage is applied (or written) to the sub-pixels of the even-numbered pixel group PGE.

In one example embodiment, the first data line DL1 connected to the first sub-pixel and the second data line DL2 connected to the second sub-pixel may be arranged in a second direction D2 in which pixel columns extend. The first data line DL1 and the second data line DL2 may be disposed between the first sub-pixel and the second sub-pixel. The third data line DL3 connected to the third sub-pixel and the fourth data line DL4 connected to the fourth sub-pixel may be arranged in the second direction D2. The third data line DL3 and the fourth data line DL4 may be disposed between the third sub-pixel and the fourth sub-pixel. In addition, the data lines may be not disposed between the second sub-pixel and the third sub-pixel and between the pixel groups PGO, PGE. Accordingly, a coupling effect between the data lines due to writing the data voltage can be reduced.

As described above, the organic light emitting display device 1000 according to example embodiments may commonly provide the emission control signal EM(k) and the initialization signal GI(k) to entire sub-pixels of single pixel row. Also, the organic light emitting display device 1000 provides the odd-numbered group gate signal to odd-numbered pixel group solely, and then provides the even-numbered group gate signal to even-numbered pixel group solely. Accordingly, a time for compensating the threshold voltage of the driving transistor TD in the sub-pixel is sufficiently secured. Therefore, the compensating operation of the threshold voltage is sufficiently performed in every frame, thereby preventing a stain occurred in high-resolution display device and improving the display quality.

In addition, in the organic light emitting display device 1000 according to example embodiments, the coupling effect between the data lines due to writing the data voltage can be reduced by arranging the data lines.

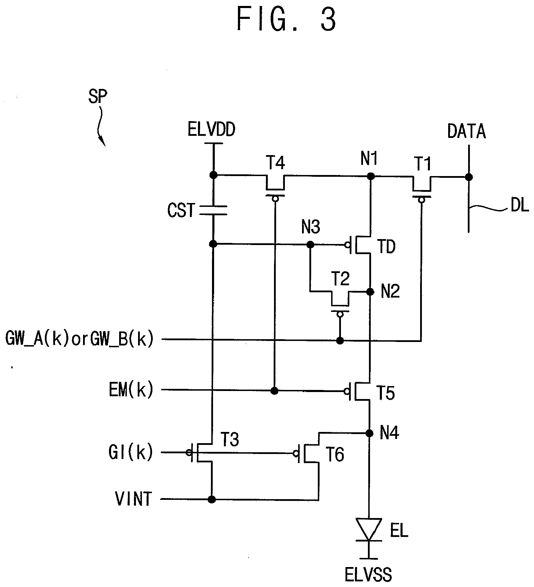

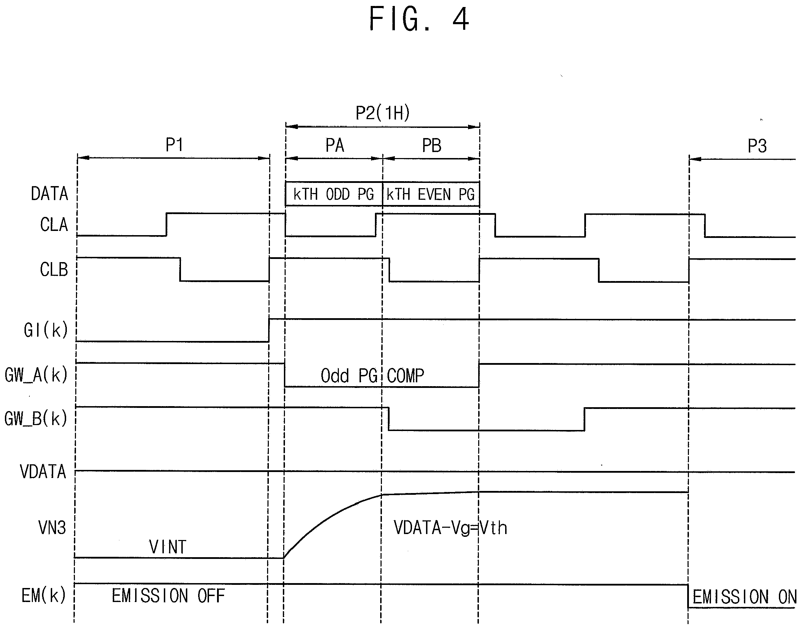

FIG. 3 is a circuit diagram illustrating an example of a sub-pixel SP included in the display panel of FIG. 2. FIG. 4 is a timing diagram illustrating an example in which the sub-pixel SP of FIG. 3 is driven in a compensation period.

Referring to FIGS. 3 and 4, each sub-pixel SP includes a driving transistor TD, first through sixth transistors T1 through T6, a storage capacitor CST, and an organic light emitting diode EL.

The driving transistor TD provides a driving current corresponding to a data signal (or data voltage) DATA to the organic light emitting diode EL. The driving transistor TD is connected between a first node N1 and a second node N2. A gate electrode of the driving transistor TD is connected to the third node N3.

The first transistor T1 provides the data signal DATA to the first node N1 in response to a first group gate signal (e.g., odd-numbered group gate signal GW_A(k)) or a second group gate signal (e.g., even-numbered group gate signal GW_B(k)). The first transistor T1 is connected between the data line DL and the first node N1. A gate electrode of the first transistor T1 receives the odd-numbered group gate signal GW_A(k) or the even-numbered group gate signal GW_B(k). When the sub-pixel SP corresponds to the odd-numbered pixel group, the first transistor T1 receives the odd-numbered group gate signal GW_A(k). When the sub-pixel SP corresponds to the even-numbered pixel group, the first transistor T1 receives the even-numbered group gate signal GW_B(k).

The second transistor T2 connects the second node N2 to a third node N3 (i.e., connect the second electrode of the driving transistor TD to the gate electrode of the driving transistor TD) in response to the odd-numbered group gate signal GW_A (k) or the even-numbered group gate signal GW_B(k). The second transistor T2 is connected between the second node N2 and the third node N3. A gate electrode of the second transistor T2 receives the odd-numbered group gate signal GW_A(k) or the even-numbered group gate signal GW_B(k). When the sub-pixel SP corresponds to the odd-numbered pixel group, the second transistor T2 receives the odd-numbered group gate signal GW_A(k). When the sub-pixel SP corresponds to the even-numbered pixel group, the second transistor T2 receives the even-numbered group gate signal GW_B(k).

The second transistor T2 is used for compensating a threshold voltage of the driving transistor TD. A diode-connection of the driving transistor TD is formed when the second transistor T2 is turned-on. Accordingly, a compensating operation for the threshold voltage of the driving transistor TD is performed.

The third transistor T3 provides an initialization voltage VINT to the third node N3 (i.e., the gate electrode of the driving transistor TD) in response to an initialization signal GI(k). The third transistor T3 is connected between an initialization power source and the third node N3. A gate electrode of the third transistor T3 receives the initialization signal GI(k). The third transistor T3 is used to initialize the gate voltage of the driving transistor TD to the initializing voltage VINT.

The fourth transistor T4 provides the first power voltage ELVDD to the first node N1 in response to an emission control signal EM(k). The fourth transistor T4 is connected between the first node N1 and a first power source providing the first power voltage ELVDD. A gate electrode of the fourth transistor T4 receives the emission control signal EM(k).

The fifth transistor T5 electrically connects the driving transistor TD to an anode electrode of the organic light emitting diode EL in response to the emission control signal EM(k). The fifth transistor T5 is connected between the second node N2 and a fourth node N4. A gate electrode of the fifth transistor T5 receives the emission control signal EM(k).

The sixth transistor T6 provides the initialization voltage VINT to the fourth node N4 (i.e., the anode electrode of the organic light emitting diode EL) in response to the initialization signal GI(k). The sixth transistor T6 is connected between the initialization power source and the fourth node N4. A gate electrode of the sixth transistor T6 receives the initialization signal GI(k). The sixth transistor T6 is used to initialize the voltage of the anode electrode of the organic light emitting diode EL to the initializing voltage VINT.

The storage capacitor CST is connected between the first power source and the third node N3.

The organic light emitting diode EL is connected between the fourth node N4 and a second power source providing a second power voltage ELVSS. The second power voltage ELVSS is lower than the first power voltage ELVDD.

Hereinafter, it is assumed that the sub-pixel SP is arranged in the first pixel group (for example, the odd-numbered pixel group) of the (k)th pixel row to describe method of driving the sub-pixel SP.

As shown in FIG. 4, a single frame period for driving the sub-pixel SP includes an initialization period P1 in which a voltage Vg of the gate electrode of the driving transistor TD and a voltage of the anode electrode of the organic light emitting diode EL are initialized, a compensation period P2 in which the data voltage is written and the threshold voltage of the driving transistor TD is compensated, and an emission period P3 in which the sub-pixel SP emits light.

In the initialization period P1, the initialization signal GI(k) may correspond to the activation level and the gate signals GW_A(k) and GW_B(k) may correspond to the deactivation level. In one example of FIG. 4, the activation level may be a logic low level, and the deactivation level may be a logic high level. Accordingly, because the third transistor T3 is turned on, the voltage Vg of the gate electrode of the driving transistor TD (i.e., a voltage VN3 of the third node) is initialized to the initializing voltage VINT. Also, because the sixth transistor T6 is turned on, the voltage of the anode electrode of the organic light emitting diode EL (i.e., a voltage of the fourth node) is initialized to the initializing voltage VINT. The emission control signal EM(k) may correspond to the deactivation level during the initialization period P1.

In the compensation period P2, the odd-numbered group gate signal GW_A(k) may correspond to the activation level. The odd-numbered group gate signal GW_A(k) is provided through the odd-numbered group gate line connected to the sub-pixel SP. The second transistor T2 and the first transistor T1 may be turned on during the compensation period P2. Therefore, the diode connection of the driving transistor TD may be formed. In the compensation period P2, the initialization signal GI(k) and the emission control signal EM(k) may correspond to the deactivation level.

The compensation period P2 includes a first compensation period PA in which the data voltage VDATA is applied to the driving transistor TD through the data line DL to write the data voltage VDATA and compensate the threshold voltage of the driving transistor TD, and a second compensation period PB in which the threshold voltage compensating operation is maintained by the data line DL in a floating status. The data signal DATA corresponding to the data voltage VDATA may be set every about 1/2 horizontal period in synchronization with the first and second clock signals CLA and CLB. Therefore, as shown in FIG. 2, the data line DL, of which connection with the sub-pixel SP is controlled by the first clock signal CLA, transfers the data voltage VDATA to the sub-pixel SP only during the first compensation period PA.

During the first compensation period PA, the data voltage VDATA is applied to the sub-pixel SP, and then the threshold voltage of the driving transistor TD is compensated. For example, during the compensation period P2, the gate electrode of the driving transistor TD and the second electrode of the driving transistor TD are connected to each other (i.e., diode-connection), and then the data voltage VDATA is applied to the first electrode of the driving transistor TD. Accordingly, a voltage of the gate electrode of the driving transistor TD may be determined based on the the data voltage VDATA and the threshold voltage of the driving transistor TD such that the driving current is determined based on the data voltage VDATA regardless of the threshold voltage of the driving transistor TD. When the display device has a high-resolution or the display device is driven at high-frequency, the first compensation period PA is relatively short (e.g., lesser than 3 microsecond). Accordingly, the compensation of the threshold voltage may not be sufficiently performed.

During the second compensation period PB, the data line DL is in floating status because the first clock signal CLA corresponds to the deactivation level. During the second compensation period PB, the compensating operation of the threshold voltage is maintained by the voltage remaining (or stored) in the floating data line DL. Therefore, the sub-pixel SP may sufficiently perform the compensating operation of the threshold voltage within one horizontal period (1H).

In this case, because the driving transistor TD is turned off (or almost turned off) during the second compensation period PB, the voltage of the gate electrode of the driving transistor TD may not affected by a change in the data signal DATA by the first and second clock signals CLA and CLB. Therefore, a time for compensating the threshold voltage may be sufficiently secured because the compensation period P2 includes the first compensation period PA during which the data voltage VDATA is applied to the driving transistor TD and the second compensation period PB during which the compensating operation of the threshold voltage is maintained by the voltage of the floating data line DL.

In one example embodiment, the even-numbered group gate signal GW_B(k) may correspond to the activation level in the second compensation period PB. Therefore, in the second compensation period PB, the sub-pixels of the even-numbered pixel group of the (k)th pixel row may perform the compensating operation of the threshold voltage by applying the data voltage VDATA to the driving transistor TD.

Thereafter, in the emission period P3, the emission control signal EM(k) may correspond to the activation level. The fourth and fifth transistors T4 and T5 may be turned on. Accordingly, the organic light emitting diode EL emits light with a luminance corresponding to the data voltage VDATA during the emission period P3.

As described above, the sub-pixel SP included in the organic light emitting display device 1000 driven in the DEMUX driving manner may perform the compensating operation sufficiently during the first compensation period PA in which the data voltage VDATA is applied to the sub-pixel SP and the second compensation period PB in which the threshold voltage compensation is maintained by the voltage remaining in the floating data line DL. Therefore, the time for compensating the threshold voltage may be sufficiently ensured in the high-resolution display device in which one horizontal period (1H) is relatively short, thereby preventing stains and improving the display quality.

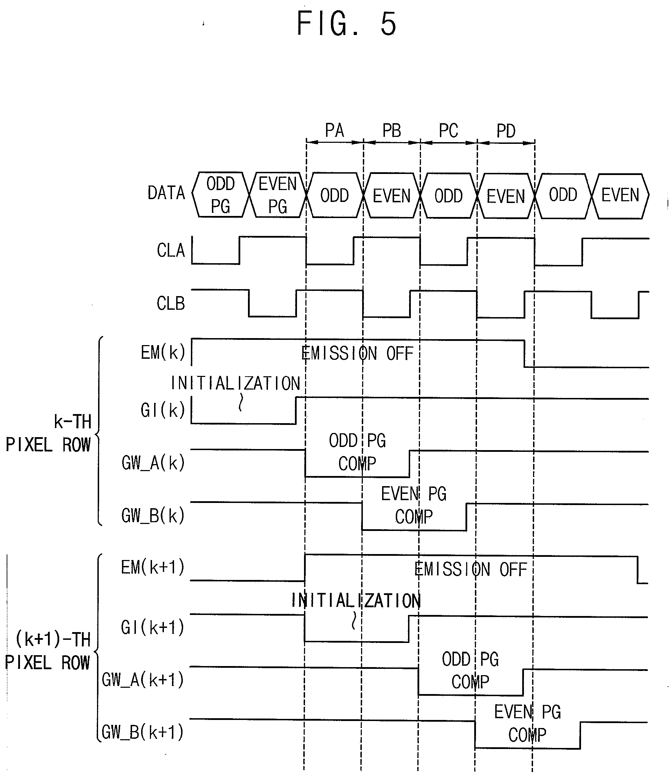

FIG. 5 is a timing diagram illustrating one example of signals for driving the display panel of FIG. 2.

Referring to FIG. 5, the first pixel group and the second pixel group of the (k)th pixel row may simultaneously perform initialization operation and emission operation, and may independently perform data writing and threshold voltage compensating operation. Here, the first pixel group may be an odd-numbered pixel group, and the second pixel group may be an even-numbered pixel group. The first group gate signal applied to the (k)th pixel row may be the (k)th odd-numbered group gate signal GW_A (k), and the second group gate signal applied to the (k)th pixel row may be the (k)th even-numbered group gate signal GW_B(k).

The (k)th initialization signal GI(k) corresponding to the activation level may be applied to entire sub-pixels in the (k)th pixel row commonly. Therefore, the initialization operation may be simultaneously performed in entire sub-pixels in the (k)th pixel rows.

The (k)th odd-numbered group gate signal GW_A(k) may correspond to the activation level during the first and second compensation periods PA, PB. Therefore, the data writing and threshold voltage compensating operation may be performed in the sub-pixels included in the odd-numbered pixel group of the (k)th pixel row. However, the data voltage may be changed in synchronization with the first and second clock signals CLA and CLB, and then the connection of the corresponding data line may be also switched. Therefore, in the odd-numbered pixel group of the (k)th pixel row, the threshold voltage compensation may be performed by applying the data voltage VDATA during the first compensation period PA, and then the threshold voltage compensating operation may be maintained by the voltage of the floating data line during the second compensation period PB

On the other hand, the (k)th even-numbered group gate signal GW_B(k) may corresponding to the activation level during the second compensation period PB and a third compensation period PC. Thus, the (k)th odd-numbered group gate signal GW_A(k) may overlap a part of the (k)th even-numbered group gate signal GW_B(k). In one example embodiment, the (k)th even-numbered group gate signal GW_B(k) may be delayed by 1/2 horizontal period from the (k)th odd-numbered group gate signal GW_A(k).

Therefore, during the second compensation period PB, the odd-numbered pixel group of the (k)th pixel row may maintain the compensating operation of the threshold voltage. At the same time, during the second compensation period PB, the even-numbered pixel group of the (k)th pixel row may perform the compensating operation of the threshold voltage by applying the data voltage VDATA to the sub-pixel.

During the third compensation period PC, the even-numbered pixel group of the (k)th pixel row may maintain the compensating operation of the threshold voltage by the voltage of the floating data line. At the same time, during the third compensation period PC, the (k+1)th odd-numbered group gate signal GW_A(k+1) of the (k+1)th pixel row may correspond to the activation level. Therefore, the odd-numbered pixel group of the (k+1)th pixel row may perform the compensating operation of the threshold voltage by applying the data voltage VDATA to the sub-pixel during the third compensation period PC.

In a similar manner, during a fourth compensation period PD, the odd-numbered pixel group of the (k+1)th pixel row may maintain the compensating operation of the threshold voltage by the voltage of the floating data line, and the even-numbered pixel group of the (k+1)th pixel row may perform the compensating operation of the threshold voltage by applying the data voltage VDATA.

After the fourth compensation period PD, the (k)th emission control signal EM(k) corresponding to the activation level may be commonly applied to entire sub-pixels in the (k)th pixel row. Therefore, entire sub-pixels in the (k)th pixel row may simultaneously emit light.

As described above, the odd-numbered group gate signal and the even-numbered group gate signal are partially overlapped such that the odd-numbered pixel group and the even-numbered pixel group perform different compensating operations at the same time. Further, because two types of compensating operations are performed for each sub-pixel, the time for compensating the threshold voltage may be sufficiently secured.

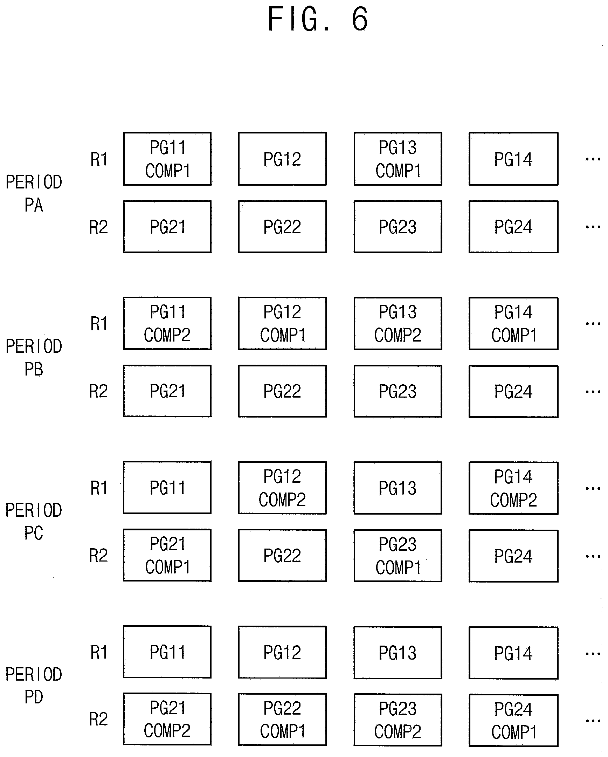

FIG. 6 is a diagram for describing operations of pixel groups in the compensation period according to the timing diagram of FIG. 5.

Referring to FIGS. 5 and 6, the threshold voltage compensating operation for the (k)th pixel row (e.g., the first pixel row R1) may be performed during the first to third compensation periods PA, PB and PC. The threshold voltage compensating operation for the (k+1)th pixel row (e.g., the second pixel row R2) may be performed during the third and fourth compensation periods PC and PD.

During the first compensation period PA, the odd-numbered pixel groups PG11, PG13, ... of the first pixel row R1 may perform a first compensating operation COMP1. Here, the first compensating operation COMP1 represents an operation of compensating the threshold voltage by applying the data voltage to the driving transistor TD in which the diode-connection is formed.

During the second compensation period PB, the odd-numbered pixel groups PG11, PG13, ... of the first pixel row R1 may perform a second compensating operation COMP2. Here, the second compensating operation COMP2 represents an operation of maintaining the threshold voltage compensating operation by a voltage remaining (or stored) in the floating data line. At the same time, the even-numbered pixel groups PG12, PG14, ... of the first pixel row R1 may perform the first compensating operation COMP1.

During the third compensation period PC, the even-numbered pixel groups PG12, PG14, ... of the first pixel row R1 may perform the second compensating operation COMP2. At the same time, during the third compensation period PC, the odd-numbered pixel groups PG21, PG23, ... of the second pixel row R2 may perform the first compensating operation COMP1.

During the fourth compensation period PD, the odd-numbered pixel groups PG21, PG23, ... of the second pixel row R2 may perform the second compensating operation COMP2. At the same time, during the fourth compensation period PD, the even-numbered pixel groups PG22, PG24, ... of the second pixel row R2 may perform the first compensating operation COMP1.

In a similar manner, the compensating operation may be sequentially performed until the last pixel row. Therefore, time for compensating the threshold voltage of the driving transistor may be sufficiently secured, and the display quality can be improved.

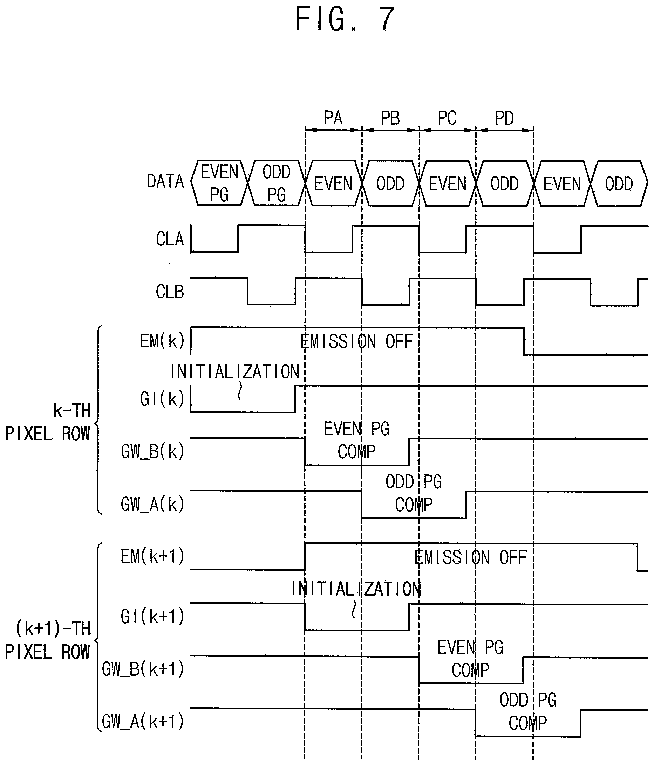

FIG. 7 is a timing diagram illustrating another example of signals for driving the display panel of FIG. 2.

A method of driving the display panel according to the present embodiment is substantially the same as the method of driving the display panel of the embodiment described in FIGS. 5 and 6, except that the order of providing the even-numbered group gate signal and the odd-numbered group gate signal. Therefore, the same reference numerals will be used to refer to the same or like parts as those described in the previous embodiment of FIGS. 5 and 6, and any repetitive explanation concerning the above elements will be omitted.

Referring to FIG. 7, the threshold voltage compensation for the even-numbered pixel group may be performed prior to the threshold voltage compensation for the odd-numbered pixel group in each pixel row.

During the first compensation period PA, the even-numbered pixel group of the (k)th pixel row may perform the threshold voltage compensating operation (i.e., the first compensating operation) based on the data voltage VDATA by the (k)th even-numbered group gate signal GW_B(k).

During the second compensation period PB, the even-numbered pixel group of the (k)th pixel row may perform the threshold voltage compensating operation (i.e., the second compensating operation) based on the voltage of the floating data line by the (k)th even-numbered group gate signal GW_B(k). At the same time, during the second compensation period PB, the odd-numbered pixel group of the (k)th pixel row may perform the threshold voltage compensating operation (i.e., the first compensating operation) based on the data voltage VDATA by the (k)th odd-numbered group gate signal GW_A(k).

During the third compensation period PC, the odd-numbered pixel group of the (k)th pixel row may perform the threshold voltage compensating operation (i.e., the second compensating operation) based on the voltage of the floating data line by the (k)th odd-numbered group gate signal GW_A(k). At the same time, during the third compensation period PC, the even-numbered pixel group of the (k+1)th pixel row may perform the threshold voltage compensating operation (i.e., the first compensating operation) based on the data voltage VDATA by the (k+1)th even-numbered group gate signal GW_B(k+1).

During the fourth compensation period PD, a compensating operation for the (k+1)th pixel row may be performed in a similar manner to the compensating operation for the (k)th pixel row performed in the second compensation period PB.

Accordingly, time for compensating the threshold voltage of the organic light emitting display device may be sufficiently secured. However, the manner of distinguishing the pixel groups and the order of providing the gate signal are not limited thereto.

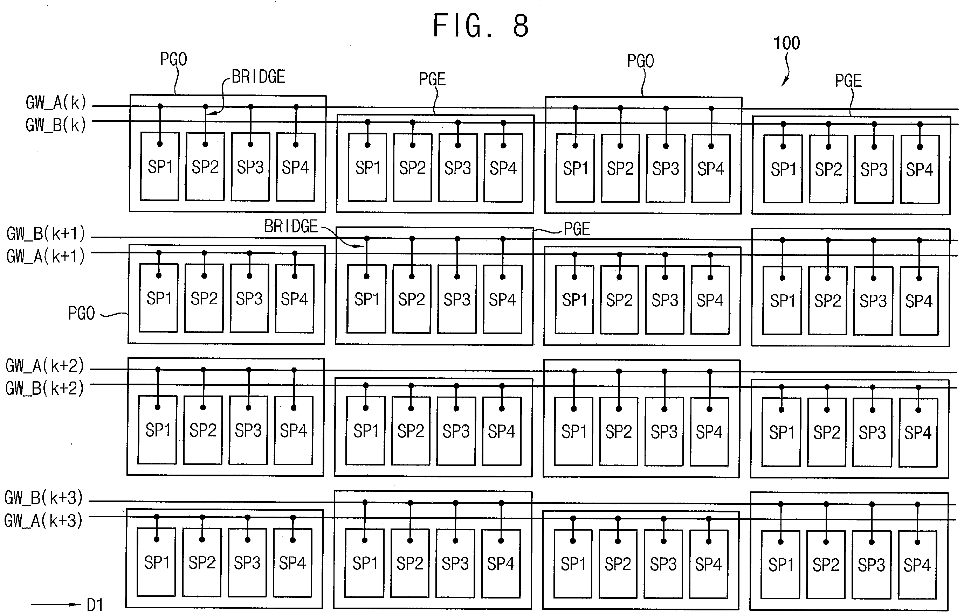

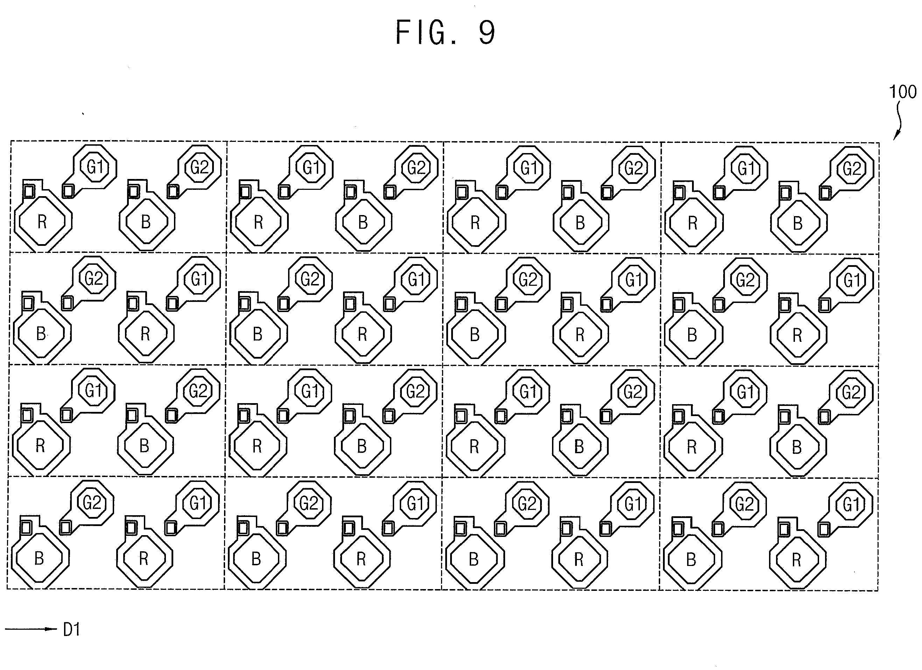

FIG. 8 is a diagram illustrating an example of an arrangement in which first group gate lines and second group gate lines are connected to pixel groups in the display panel of FIG. 2. FIG. 9 is a diagram schematically illustrating an example of pixel groups included in the display panel of FIG. 2.

Referring to FIGS. 2, 8, and 9, the first group gate lines are connected to the first pixel groups in each pixel row respectively, and the second group gate lines are connected to the second pixel groups in each pixel row respectively. In one example embodiment, the first group gate lines are odd-numbered group gate lines GW_A(k) to GW_A(k+3). The first pixel groups are odd-numbered pixel groups PGO. The second group gate lines are even-numbered group gate lines GW_B(k) to GW_B(k+3). The second pixel groups are even-numbered pixel groups PGE.

The odd-numbered group gate lines GW_A(k) to GW_A(k+3) and the even-numbered group gate lines GW_B(k) to GW_B(k+3) may be extended in a first direction D1 in which the pixel rows extend. In one example embodiment, the (k)th odd-numbered group gate line GW_A(k) for providing the (k)th odd-numbered group gate signal to the (k)th pixel row may be disposed farther from the first and second transistors of the sub-pixels included in the (k)th pixel row than the (k)th even-numbered group gate line GW_B(k) for providing the (k)th even-numbered group gate signal to the (k)th pixel row. As shown in FIG. 8, the (k)th odd-numbered group gate line GW_A(k) may be disposed farther from the sub-pixels of the (k)th pixel row than the (k)th even-numbered group gate line GW_B(k) . Here, the first and second transistors in the sub-pixel are switch transistors connected to the (k)th odd-numbered group gate line GW_A(k) or the (k)th even-numbered group gate line GW_B(k). The (k)th odd-numbered group gate line GW_A (k) may be connected to the gate electrodes of the first and second transistors by a bridge structure.

In the (k+1)th pixel row adjacent to the (k)th pixel row, the gate lines may be arranged in a connection structure opposite to the (k)th pixel row. In one example embodiment, the (k+1)th even-numbered group gate line GW_B(k+1) may be disposed farther from the first and second transistors of the sub-pixels included in the (k+1)th pixel row than the (k+1)th odd-numbered group gate line GW_A(k+1). As shown in FIG. 8, the (k+1)th even-numbered group gate line GW_B(k+1) may be disposed farther from the sub-pixels included in the (k+1)th pixel row than the (k+1)th odd-numbered group gate line GW_A(k+1). The (k+1)th even-numbered group gate line GW_B(k+1) may be connected to the first and second transistors by the bridge structure.

In the (k)th pixel row, the odd-numbered pixel group PGO may be connected to the gate line disposed on the farther side from the pixel group through the bridge structure. Here, the bridge structure electrically separates the odd-numbered group gate line and the even-numbered group gate line at a crossing point of the gate lines using an insulating material disposed at the crossing point. In the (k+1)th pixel row, the odd-numbered pixel group PGO may be connected to the gate line disposed on the near side from the pixel group. On the other hand, in the (k)th pixel row, the even-numbered pixel group PGE may be connected to the gate line disposed on the near side from the pixel group. In the (k+1)th pixel row, the even-numbered pixel group PGE may be connected to the gate line disposed on the farther side from the pixel group through the bridge structure.

Therefore, even if a variation due to the resistance difference between the odd-numbered group gate lines GW_A(k) to GW_A(k+3) and the even-numbered group gate lines GW_B(k) to GW_B(k+3) occurs, the deviation not be recognized by user because the distance between the pixel groups PGO, PGE and the gate lines connected thereto are changed according to the pixel rows.

As shown in FIG. 9, the display panel 100 may include a plurality of odd-numbered pixel groups PGO and a plurality of even-numbered pixel groups PGE. In one embodiment, each of the odd-numbered pixel groups PGO and the even-numbered pixel groups PGE may include four sub-pixels. For example, each of the odd-numbered pixel groups PGO and the even-numbered pixel groups PGE may include a red color sub-pixel R, a blue color sub-pixel B, a first green color sub-pixel G1, and a second green color sub-pixel G2 in a first direction D1 in which pixel rows extend. When the sub-pixels described in FIG. 9 may be connected to one of the odd-numbered group gate lines or the even-numbered group gate lines described in FIG. 8, the resistance variation is uniformly dispersed. Accordingly, the luminance deviation may be not recognized.

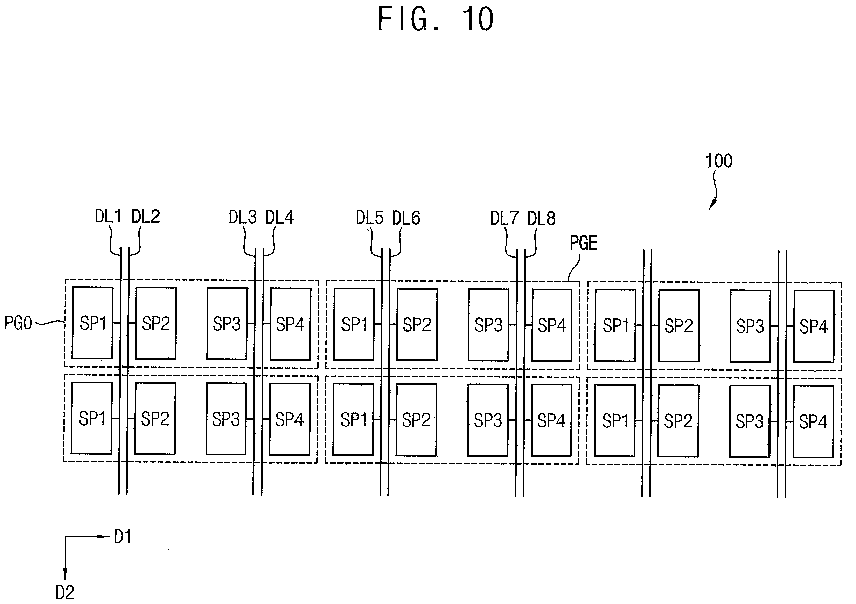

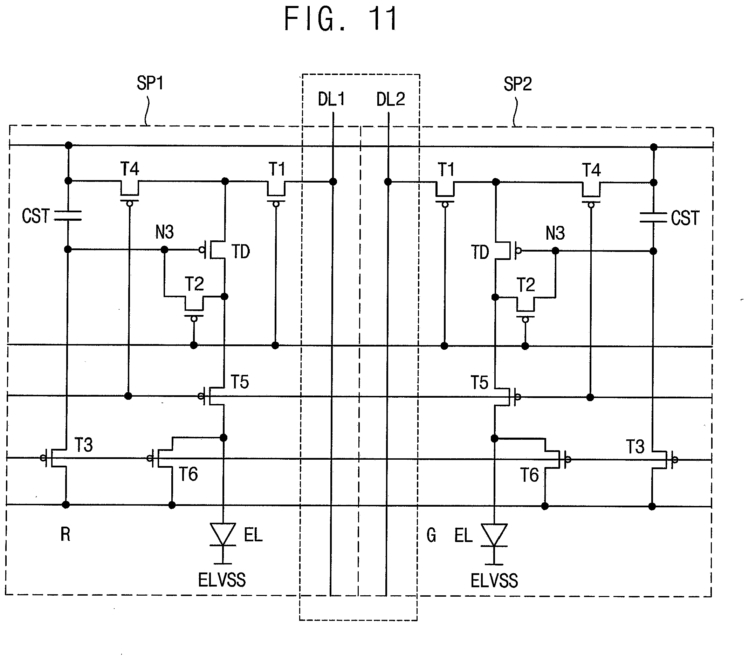

FIG. 10 is a diagram schematically illustrating an example of data lines connected to the display panel of FIG. 2. FIG. 11 is a circuit diagram illustrating an example of an arrangement of the data lines of FIG. 10.

Referring to FIGS. 2, 10, and 11, each of the odd-numbered pixel groups PGO and the even-numbered pixel groups PGE may include four sub-pixels.

Each of the odd-numbered pixel groups PGO and the even-numbered pixel groups PGE may include a first sub-pixel SP1, a second sub-pixel SP2, a third sub-pixel SP3, and a fourth sub-pixel SP4. In one example embodiment, each of the first to fourth sub-pixels SP1 to SP4 may emit one of red color light, blue color light, and green color light. For example, the sub-pixels of the display panel 100 may be arranged in a pentile matrix structure shown in FIG. 9. For example, the first sub-pixel SP1 may emit different color light depending on the pixel row and/or pixel groups included therein.

In each of the odd-numbered pixel groups PGO and the even-numbered pixel groups PGE, the first data line DL1 connected to the first sub-pixel SP1 and the second data line DL2 connected to the second sub-pixel SP2 may extend in a second direction D2 in which pixel columns extend. The first data line DL1 and the second data line DL2 may be disposed between the first sub-pixel SP1 and the second sub-pixel SP2.

The third data line DL3 connected to the third sub-pixel SP3 and the fourth data line DL4 connected to the fourth sub-pixel SP4 may extend in the second direction D2, and may be disposed between the third sub-pixel SP3 and the fourth sub-pixel SP4. Further, no data line may be disposed between the second sub-pixel SP2 and the third sub-pixel SP3 and between the odd-numbered pixel group PGO and the even-numbered pixel group PGE.

As shown in FIG. 11, the data lines DL1 and DL2 connected to the two adjacent sub-pixels SP1 and SP2 respectively may be disposed between the sub-pixels SP1 and SP2. Adjacent sub-pixels (e.g., the first sub-pixel SP1 and the second sub-pixel SP2) may have structures symmetrical in the second direction D2 to form the connection with the data lines DL1 and DL2 . In addition, the second sub-pixel SP2 and the third sub-pixel SP3 between which the data lines are not arranged may also have symmetrical structures.

Therefore, in the organic light emitting display device 1000 driven in DEMUX driving manner, the coupling effect due to switching data lines can be reduced by the symmetrical structures of sub-pixels and arrangement of the data lines.

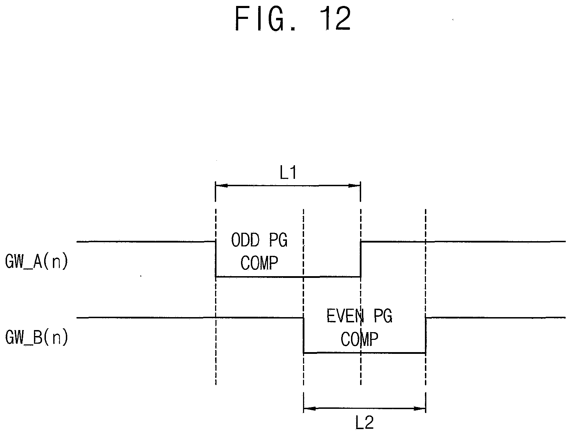

FIG. 12 is a diagram illustrating an example of a first group gate signal and a second group gate signal generated by the organic light emitting display device of FIG. 1.

Referring to FIGS. 5 and 12, each of the sub-pixels may perform the above-described two types of threshold voltage compensating operations (i.e., the first compensating operation and the second compensating operation) based on the first group gate signal (e.g., the odd-numbered group gate signal) or the second group gate signal (e.g., the even-numbered group gate signal) to sufficiently secure the time for compensating the threshold voltage.

In one example embodiment, a length L1 of the activation period of the first group gate signal (or odd-numbered group gate signal GW_A(n)) may be different from a length L2 of the activation period of the second group gate signal (or even-numbered group gate signal GW_B(n)). For example, the odd-numbered group gate signal GW_A(n) and the even-numbered group gate signal GW_B(n) may be output from different gate drivers. Thus, the length L1 of the activation period of the odd-numbered group gate signal GW_A(n) and the length L2 of the activation period of the even-numbered group gate signal GW_B(n) may be different from each other by providing clock signals having different widths to the gate drivers respectively. For example, the length L1 of the activation period of the odd-numbered group gate signal GW_A(n) may be longer than the length L2 of the activation period of the even-numbered group gate signal GW_B(n). In contrast, the length L1 of the activation period of the odd-numbered group gate signal GW_A(n) may be shorter than the length L2 of the activation period of the even-numbered group gate signal GW_B(n).

Two gate lines (i.e., the odd-numbered group gate line and the even-numbered group gate line) may be apart from one pixel row at different distances. Accordingly, there is a possibility that a delay of the gate signal due to the resistance difference between the odd-numbered group gate line and the even-numbered group gate line occurs. To prevent the delay of the gate signal, the length L1 of the activation period of the odd-numbered group gate signal GW_A(n) and the length L2 of the activation period of the even-numbered group gate signal GW_B (n) may be set differently.

Therefore, the threshold voltage compensation time for the odd-numbered pixel group and the threshold voltage compensation time for the even-numbered pixel group can be separated from each other. The delay of the gate signal due to the resistance difference between the odd-numbered group gate line and the even-numbered group gate line can be reduced and the image quality can be improved.

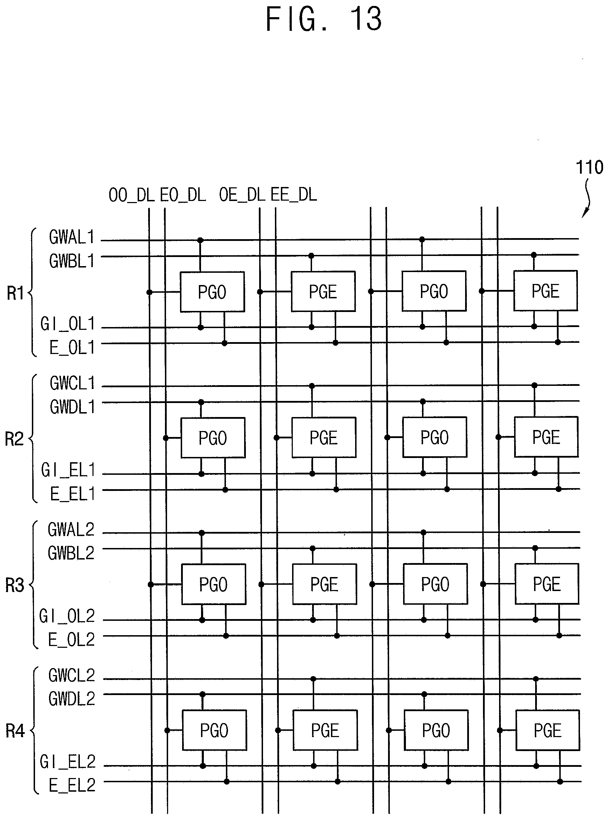

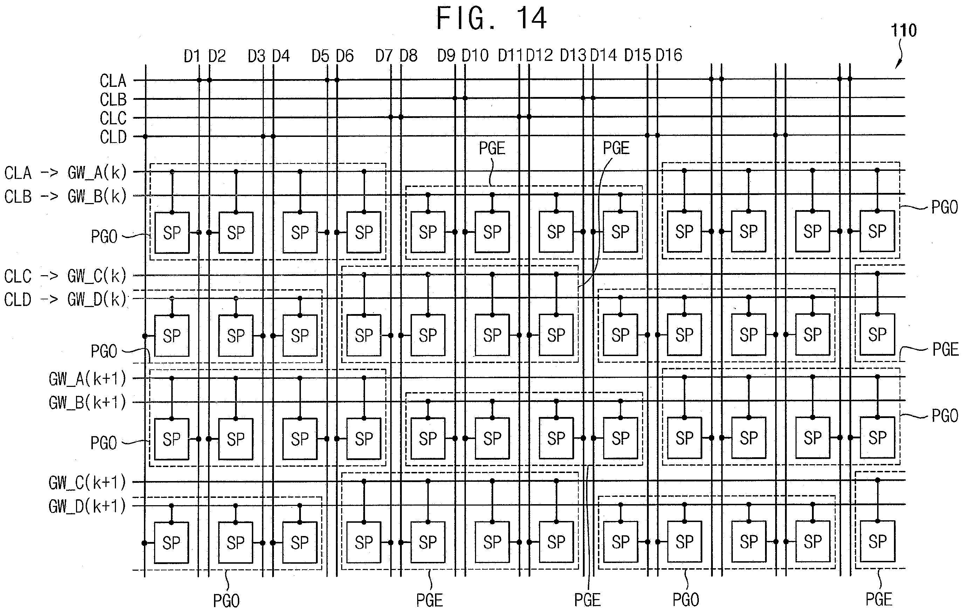

FIG. 13 is a diagram schematically illustrating a display panel 110 included in the organic light emitting display device according to an example not forming part of an embodiment. FIG. 14 is a diagram schematically illustrating an example of gate signals and data signals provided to the display panel 110 of FIG. 13.

The organic light emitting display device according to the present example is substantially the same as the organic light emitting display device of the example embodiment described in FIG. 1, except that odd-numbered pixel rows and even-numbered pixel rows are individually driven and the number of the data line increases twice compared to the organic light emitting display device of FIG. 1. Therefore, the same reference numerals will be used to refer to the same or like parts as those described in the embodiment of FIG. 1, and any repetitive explanation concerning the above elements will be omitted.

Referring to FIGS. 1, 13, and 14, the display panel 110may include the odd-numbered pixel group PGO and the even-numbered pixel group PGE each including a plurality of sub-pixels. The organic light emitting display device may drive the display panel 110 in a DEMUX driving manner in which odd-numbered pixel rows and even-numbered pixel rows are driven individually.

The organic light emitting display device may include the display panel 110, a gate driver, a data driver, a data divider, and a timing controller. The operations of the gate driver, the data driver, the data divider, and the timing controller are substantially the same as those of FIG. 1 except for the operation timing. Therefore, duplicated descriptions will be omitted.

The pixel rows of the display panel 110 may be divided into first pixel rows and second pixel rows. For example, the first pixel row may be the odd-numbered pixel row, and the second pixel row may be the even-numbered pixel row next to the first pixel row. Also, a first initialization signal and a first emission control signal may be an odd-numbered initialization signal and an odd-numbered emission control signal provided to the first pixel row. Likewise, a second initialization signal and a second emission control signal may be an even-numbered initialization signal and an even-numbered emission control signal provided to the second pixel row.

Hereinafter, it is assumed that the pixel rows are divided into odd-numbered pixel rows and even-numbered pixel rows to drive the display panel. However, the method of classifying the first pixel row and the second pixel row is not limited thereto.

The odd-numbered pixel rows R1, R3, ... of the display panel 110 may be connected to the odd-numbered initialization lines GI_OL1, GI_OL2, ... and odd-numbered emission control lines E_OL1, E_OL2, .... The even-numbered pixel rows R2, R4, ... may be connected to the even-numbered initialization lines GI_EL1, GI_EL2, ... and even-numbered emission control lines E_EL1, E_EL2, .... In addition, the number of data lines in the display device according to the present example increases twice compared to the organic light emitting display device of FIG. 1.

The odd-numbered initialization signal may be sequentially provided to the odd-numbered pixel rows R1, R3, ... through the odd-numbered initialization lines GI_OL1, GI_OL2, .... The even-numbered initialization signal may be sequentially provided to the even-numbered pixel rows R2, R4, ... through the even-numbered initialization lines GI_EL1, GI_EL2, .... The initialization signals provided to adjacent pixel rows may have an interval of approximately one horizontal period.

The odd-numbered emission control signal may be sequentially provided to the odd-numbered pixel rows R1, R3, ... through the odd-numbered emission control lines E_OL1, E_OL2, .... The even-numbered emission control signal may be sequentially provided to the even-numbered pixel rows R2, R4, ... through the even-numbered emission control lines E_EL1, E_EL2, .... The emission control signals provided to adjacent pixel rows may have an interval of approximately one horizontal period.

Further, the first pixel groups PGO (hereinafter, the odd-numbered pixel group PGO) of the odd-numbered pixel rows R1, R3, ... may be connected to the first group gate lines (hereinafter, <odd-numbered row, odd-numbered group> gate lines GWAL1, GWAL2). The second pixel groups PGE (hereinafter, the even-numbered pixel group PGE) of the odd-numbered pixel rows R1, R3, ... may be connected to the second group gate lines (hereinafter, <odd-numbered row, even-numbered group> gate lines GWBL1, GWBL2).

Likewise, the third pixel groups PGO (hereinafter, the odd-numbered pixel group PGO) of the even-numbered pixel rows R2, R4, ... may be connected to the third group gate lines (hereinafter, <even-numbered row, odd-numbered group> gate lines GWDL1, GWDL2). The fourth pixel groups PGE (hereinafter, the even-numbered pixel group PGE) of the even-numbered pixel rows R2, R4, ... may be connected to the fourth group gate lines (hereinafter, <even-numbered row, even-numbered group> gate lines GWCL1, GWCL2).

The first group gate signal (hereinafter, <odd-numbered row, odd-numbered group> gate signal GW_A(k), GW_A(k+1)) may be sequentially provided to the odd-numbered pixel rows R1, R3, ... through the <odd-numbered row, odd-numbered group> gate lines GWAL1, GWAL2, .... according to the first clock signal CLA.

The second group gate signal (hereinafter, <odd-numbered row, even-numbered group> gate signal GW_B(k), GW_B(k+1)) may be sequentially provided to the odd-numbered pixel rows R1, R3, ... through the <odd-numbered row, even-numbered group> gate lines GWBL1, GWBL2, .... according to the second clock signal CLB. The second clock signal CLB may be delayed by a quarter period of the clock signal from the first clock signal CLA.

The fourth group gate signal (hereinafter, <even-numbered row, even-numbered group> gate signal GW_C(k), GW_C(k+1) may be sequentially provided to the even-numbered pixel rows R2, R4, ... through the <even-numbered row, even-numbered group> gate lines GWCL1, GWCL2, .... according to the third clock signal CLC. The third clock signal CLC may be delayed by a quarter period of the clock signal from the second clock signal CLB.

The third group gate signal (hereinafter, <even-numbered row, odd-numbered group> gate signal GW_D(k), GW_D(k+1)) may be sequentially provided to the even-numbered pixel rows R2, R4, ... through the <even-numbered row, odd-numbered group> gate lines GWDL1, GWDL2, .... according to the fourth clock signal CLD. The fourth clock signal CLD may be delayed by a quarter period of the clock signal from the third clock signal CLC.

The display panel 110 may include first group data lines, second group data lines, third group data lines, and fourth group data lines. The first group data lines (hereinafter, <odd-numbered row, odd-numbered group> data lines OO_DL) may be connected to the odd-numbered pixel groups PGO of the odd-numbered pixel rows R1, R3, .... The second group data lines (hereinafter, <odd-numbered row, even-numbered group> data lines OE_DL) may be connected to the even-numbered pixel groups PGE of the odd-numbered pixel rows R1, R3, .... The third group data lines (hereinafter, <even-numbered row, odd-numbered group> data lines EO_DL) may be connected to the odd-numbered pixel groups PGO of the even-numbered pixel rows R2, R4, .... The fourth group data lines (hereinafter, <even-numbered row, even-numbered group> data lines EE_DL) may be connected to the even-numbered pixel groups PGE of the even-numbered pixel rows R2, R4, ....

The <odd-numbered row, odd-numbered group> data lines OO_DL may include four data lines for each odd-numbered pixel group PGO. As shown in FIG. 14, the <odd-numbered row, odd-numbered group> data lines OO_DL may be for transferring data voltages D1, D2, D5, D6, etc. The <odd-numbered row, odd-numbered group> data lines OO_DL may provide the data voltages D1, D2, D5, D6, etc to the display panel 110 (i.e., sub-pixels in odd-numbered pixel group of the odd-numbered pixel row) based on the first clock signal CLA. At the same time, the <odd-numbered row, odd-numbered group> gate signals GW_A(k), GW_A(k+1), ... may be applied to one of the odd-numbered pixel rows R1, R3, .... Accordingly, the odd-numbered pixel group PGO of the odd-numbered pixel row may perform the data writing and threshold voltage compensating operation.

The <odd-numbered row, even-numbered group> data lines OE_DL may include four data lines for each even-numbered pixel group PGE. As shown in FIG. 14, the <odd-numbered row, even-numbered group> data lines OE_DL may be for transferring data voltages D9, D10, D13, D14, etc. The <odd-numbered row, even-numbered group> data lines OE_DL may provide the data voltages D9, D10, D13, D14, etc to the display panel 110 (i.e., sub-pixels in even-numbered pixel group of the odd-numbered pixel row) based on the second clock signal CLB. At the same time, the <odd-numbered row, even-numbered group> gate signals GW_B(k), GW_B(k+1), ... may be applied to one of the odd-numbered pixel rows R1, R3, .... Accordingly, the even-numbered pixel group PGE of the odd-numbered pixel row may perform the data writing and threshold voltage compensating operation.

The <even-numbered row, even-numbered group> data lines EE_DL may include four data lines for each even-numbered pixel group PGE. As shown in FIG. 14, the <even-numbered row, even-numbered group> data lines EE_DL may be for transferring data voltages D7, D8, D11, D12, etc. The <even-numbered row, even-numbered group> data lines EE_DLmay provide the data voltages D7, D8, D11, D12, etc to the display panel 110 (i.e., sub-pixels in even-numbered pixel group of the even-numbered pixel row) based on the third clock signal CLC. At the same time, the <even-numbered row, even-numbered group> gate signals GW_C(k), GW_C(k+1), ... may be applied to one of the even-numbered pixel rows R2, R4, .... Accordingly, the even-numbered pixel group PGE of the even-numbered pixel row may perform the data writing and threshold voltage compensating operation.

The <even-numbered row, odd-numbered group> data lines EO_DL may include four data lines for each odd-numbered pixel group PGO. As shown in FIG. 14, the <even-numbered row, odd-numbered group> data lines EO_DL may be for transferring data voltages D3, D4, D15, D16, etc. The <even-numbered row, odd-numbered group> data lines EO_DL may provide the data voltages D3, D4, D15, D16, etc to the display panel 110 (i.e., sub-pixels in odd-numbered pixel group of the even-numbered pixel row) based on the fourth clock signal CLD. At the same time, the <even-numbered row, odd-numbered group> gate signals GW_D(k), GW_D(k+1), ... may be applied to one of the even-numbered pixel rows R2, R4, .... Accordingly, the odd-numbered pixel group PGO of the even-numbered pixel row may perform the data writing and threshold voltage compensating operation.

In summary, the data writing and threshold voltage compensating operation may be performed in an order of the odd-numbered pixel group of the (2k-1)th pixel row, the even-numbered pixel group of the (2k-1)th pixel row, the even-numbered pixel group of the (2k)th pixel row, and the odd-numbered pixel group of the (2k)th pixel row. In this way, when the display device is driven at high-frequency (e.g., 120 Hz), the compensation time can be ensured sufficiently (e.g., longer than two horizontal periods).

In one example embodiment, the (k)th <odd-numbered row, odd-numbered group> gate line connected to the (2k-1)th pixel row may be disposed farther from the (2k-1)th pixel row than the (k)th <odd-numbered row, even-numbered group> gate line and may be connected to each of the sub-pixels in the odd-numbered pixel group by a bridge structure. In addition, the (k)th <even-numbered row, even-numbered group> gate line connected to the (2k)th pixel row may be disposed farther from the (2k)th pixel row than the (k)th <even-numbered row, odd-numbered group> gate line and may be connected to each of the sub-pixels in the even-numbered pixel group by the bridge structure.

For example, as shown in FIGS. 13 and 14, the first <odd-numbered row, odd-numbered group> gate line GWAL1 may be disposed farther from the first pixel row R1 than the first <odd-numbered row, even-numbered group> gate line GWBL1. The first <odd-numbered row, odd-numbered group> gate line GWAL1 may be connected to each of the sub-pixels of the odd-numbered pixel group PGO by a bridge structure. Also, the first <even-numbered row, even-numbered group> gate line GWCL1 may be disposed farther from the second pixel row R2 than the first <even-numbered row, odd-numbered group> gate line GWDL1. The first < even-numbered row, even-numbered group> gate line GWCL1 may be connected to each of the sub-pixels of the even-numbered pixel group PGE by the bridge structure.

In contrast, in another example, the (k)th <odd-numbered row, even-numbered group> gate line connected to the (2k-1)th pixel row may be disposed farther from the (2k-1)th pixel row than the (k)th <odd-numbered row, odd-numbered group> gate line and may be connected to each of the sub-pixels in the even-numbered pixel group by the bridge structure. The (k)th <even-numbered row, odd-numbered group> gate line connected to the (2k)th pixel row may be disposed farther from the (2k)th pixel row than the (k)th <even-numbered row, even-numbered group> gate line and may be connected to each of the sub-pixels in the odd-numbered pixel group by the bridge structure.

Therefore, the light emitting deviations due to the resistance difference between the two-types of gate lines corresponding to one pixel row may not be recognized.

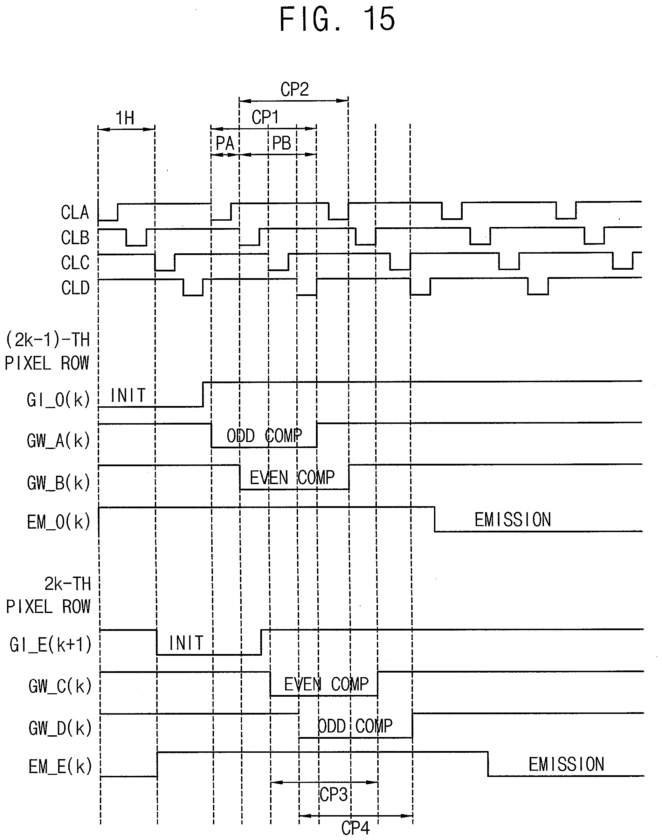

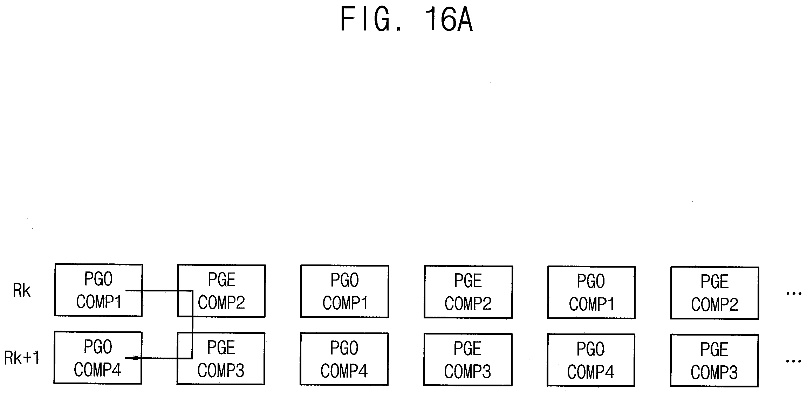

FIG. 15 is a timing diagram illustrating an example of signals for driving the display panel of FIG. 14. FIG. 16A is a diagram for describing an example in which a threshold voltage of a driving transistor is compensated in the display panel of FIG. 14.

Referring to FIGS. 14 to 16A, the display panel 110 may be driven in a manner in which single frame period includes an initialization period INIT, a compensation period ODD COMP, EVEN COMP, and an emission period EMISSION.

The odd-numbered pixel rows and the even-numbered pixel rows may be driven independently.

In one example, the first to fourth clock signals CLA, CLB, CLC, and CLD may be sequentially activated in about 1/2 horizontal period intervals. Therefore, the (k)th <odd-numbered row, even-numbered group> gate signal GW_B(k) corresponding to the (2k-1)th pixel row may be delayed by about 1/2 the horizontal period from the (k)th <odd-numbered row, odd-numbered group> gate signal GW_A(k). The (k)th <even-numbered row, even-numbered group> gate signal GW_C(k) corresponding to the (2k)th pixel row may be delayed by about 1/2 the horizontal period from the (k)th <odd-numbered row, even-numbered group> gate signal GW_B(k). The (k)th <even-numbered row, odd-numbered group> gate signal GW_D(k) may be delayed by about 1/2 the horizontal period from the (k)th <even-numbered row, even-numbered group> gate signal GW_C(k).

The odd-numbered initialization signal GI_O(k) may be activated in synchronization with the first clock signal CLA. The gate electrode of the driving transistor and the anode electrode of the organic light emitting diode in the (2k-1)th pixel row may be initialized simultaneously during the initialization period INIT.

Thereafter, the <odd-numbered row, odd-numbered group> gate signal GW_A(k) may be activated in synchronization with the first clock signal CLA, and then the data writing and threshold voltage compensating operation for the odd-numbered pixel group PGO of the (2k-1)th pixel row may be performed during the compensation period CP1. The compensation period CP1 may include a first compensation period PA and a second compensation period PB.

During the first compensation period PA, the <odd-numbered row, odd-numbered group> data line may transfer the data voltage to the driving transistor in the sub-pixel in which the diode-connection is formed such that the threshold voltage of the driving transistor is compensated (i.e., the first compensating operation). During the second compensation period PB, since the first clock signal CLA is deactivated, the <odd-numbered row, odd-numbered group> data line may be in a floating status. At this time, the threshold voltage compensating operation may be maintained based on the voltage of the floating <odd-numbered row, odd-numbered group> data line (i.e., the second compensating operation). Since the first and second compensating operations are described above with reference to FIGS. 5 and 6, duplicated descriptions will be omitted.

While the second compensating operation for odd-numbered pixel group PGO of the (2k-1)th pixel row is performed, the compensation period CP2 for the even-numbered pixel group PGE of the (2k-1)th pixel row may be performed based on the second clock signal CLB. Similar to the compensation period CP1, the first compensating operation and the second compensating operation may perform in the compensation period CP2 for the even-numbered pixel group PGE of the (2k-1)th pixel row.

The data writing and threshold voltage compensating operation for the even-numbered pixel group PGE of the (2k)th pixel row may be performed based on the third clock signal CLC. The compensation period CP3 for the even-numbered pixel group PGE of the (2k)th pixel row may be delayed by one horizontal period 1H from the compensation period CP1 for the odd-numbered pixel group PGO of the (2k-1) th pixel row. Similar to the compensation period CP1, the first compensating operation and the second compensating operation may perform in the compensation period CP3 for the even-numbered pixel group PGE of the (2k)th pixel row.

While the second compensating operation for even-numbered pixel group PGE of the (2k)th pixel row is performed, the compensation period CP4 for the odd-numbered pixel group PGO of the (2k)th pixel row may be proceeded based on the fourth clock signal CLD. Similar to the compensation period CP3, the first compensating operation and the second compensating operation may be performed in the compensation period CP4 for the odd-numbered pixel group PGO of the (2k)th pixel row.

Thereafter, entire sub-pixels of the (2k-1)th pixel row may emit light based on the (k)th odd-numbered emission control signal EM_O(k). Likewise, entire sub-pixels of the (2k)th pixel row may emit light based on the (k)th even-numbered emission control signal EM_E(k).

The data writing and threshold voltage compensating operation may be started by the first through fourth clock signals CLA, CLB, CLC, and CLD. For example, as shown in FIG. 15, the third clock signal CLC may be for the even-number pixel group of the even-number pixel row. However, the order of the compensating operation is not limited thereto.

As shown in FIG. 16A, the data writing and threshold voltage compensating operation may be started sequentially. In the first place, the odd-numbered pixel group PGO of the (k)th pixel row Rk may start to perform the data writing and threshold voltage compensating operation (COMP1). In the second place, the even-numbered pixel group PGE of the (k)th pixel row Rk may start to perform the data writing and threshold voltage compensating operation (COMP2). In the third place, the even-numbered pixel group PGE of the (k+1)th pixel row Rk+1 may start to perform the data writing and threshold voltage compensating operation (COMP3). In the fourth place, the odd-numbered pixel group PGO of the (k+1)th pixel row Rk+1 may start to perform the data writing and threshold voltage compensating operation (COMP4). In addition, the compensation periods may be partially overlapped as shown in FIG. 15. However, the order of the data writing and threshold voltage compensating is not limited thereto.

As described above, the organic light emitting display device separates the odd-numbered pixel group and the even-numbered pixel group and separates the odd-numbered pixel row and even-numbered pixel row to perform the compensating operation of the threshold voltage of the driving transistors in a partially overlapping manner. Accordingly, the compensation period may be sufficiently secured in the display device driven at high frequency above 120Hz. For example, the threshold voltage compensation time is about 2.17um in a conventional display device driven in DEMUX driving manner at 60Hz. Further, the threshold voltage compensation time is about 1.08um in a conventional display device driven in DEMUX driving manner at 120Hz. However, the organic light emitting display device according to present example embodiment can secure the threshold voltage compensation time of more than 6.5um (about 2 horizontal period) when the display device is driven at 120 Hz. Therefore, degradation of image quality such as stain caused when the high-resolution display device is driven at high-frequency can be prevented.

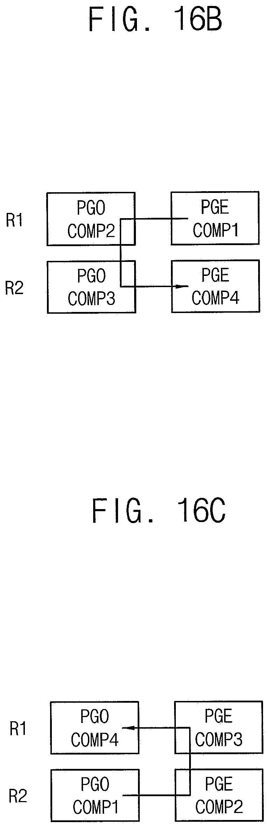

FIGS. 16B to 16D are diagrams for describing examples in which a threshold voltage of a driving transistor is compensated in the display panel of FIG. 14.

Referring to FIGS. 16B to 16D, the data writing and threshold voltage compensating operation for the even-numbered pixel group and the odd-numbered pixel group included in each pixel row may be controlled by the timing of the first to fourth clock signals.

The data writing and the threshold voltage compensating operation may be performed in an order of the even-numbered pixel group of the (2k-1)th pixel row, the odd-numbered pixel group of the (2k-1)th pixel row, the odd-numbered pixel group of the (2k)th pixel row, and the even-numbered pixel group of the (2k)th pixel row, where k is an integer greater than 0. For example, as shown in FIG. 16B, the data writing and threshold voltage compensating operation may be performed in the order of the even-number pixel group PGE of the first pixel row R1, the odd-number pixel group PGO of the first pixel row R1, the odd-numbered pixel group PGO of the second pixel row R2, and the even-numbered pixel group PGE of the second pixel row R2 (i.e., in the order of COMP1 -> COMP2 -> COMP3 -> COMP4, referring to FIG. 16B).

The data writing and the threshold voltage compensating operation may be performed in an order of the odd-numbered pixel group of the (2k)th pixel row, the even-numbered pixel group of the (2k)th pixel row, the even-numbered pixel group of the (2k-1)th pixel row, and the odd-numbered pixel group of the (2k-1)th pixel row, where k is an integer greater than 0. For example, as shown in FIG. 16C, the data writing and threshold voltage compensating operation may be performed in the order of the odd-number pixel group PGO of the second pixel row R2, the even-number pixel group PGE of the second pixel row R2, the even-numbered pixel group PGE of the first pixel row R1, and the odd-numbered pixel group PGO of the first pixel row R1 (i.e., in the order of COMP1 -> COMP2 -> COMP3 -> COMP4, referring to FIG. 16C).

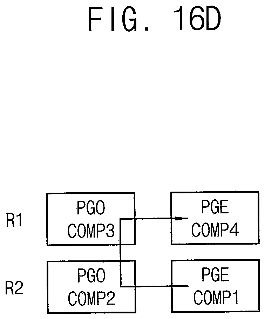

The data writing and the threshold voltage compensating operation may be performed in an order of the even-numbered pixel group of the (2k)th pixel row, the odd-numbered pixel group of the (2k)th pixel row, the odd-numbered pixel group of the (2k-1)th pixel row, and the even-numbered pixel group of the (2k-1)th pixel row, where k is an integer greater than 0. For example, as shown in FIG. 16D, the data writing and threshold voltage compensating operation may be performed in the order of the even-number pixel group PGE of the second pixel row R2, the odd-number pixel group PGO of the second pixel row R2, the odd-numbered pixel group PGO of the first pixel row R1, and the even-numbered pixel group PGE of the first pixel row R1 (i.e., in the order of COMP1 -> COMP2 -> COMP3 -> COMP4, referring to FIG. 16D).

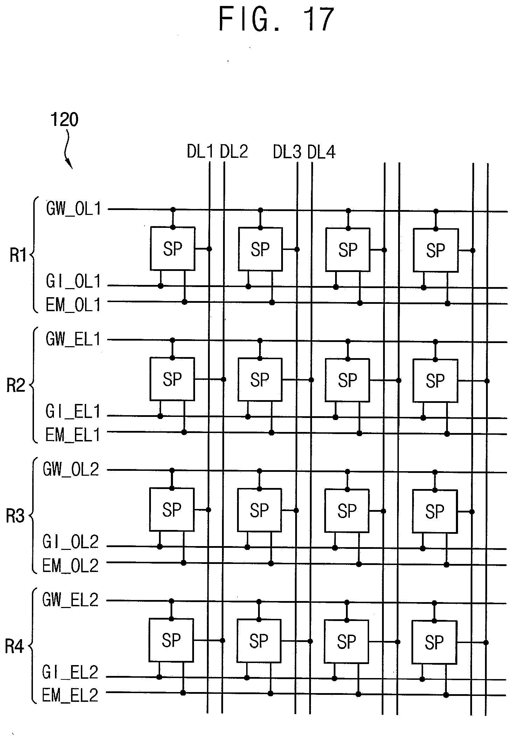

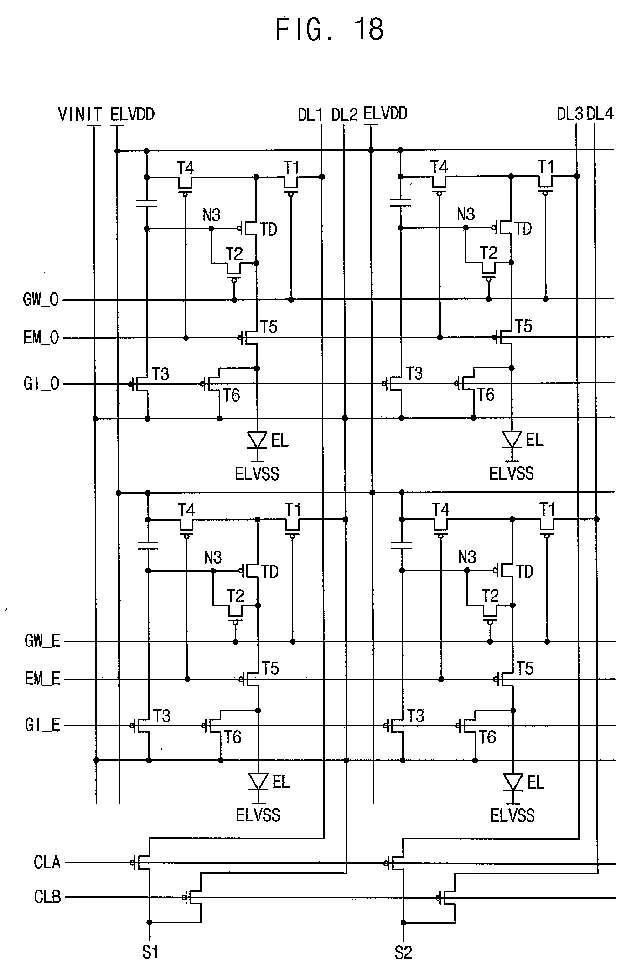

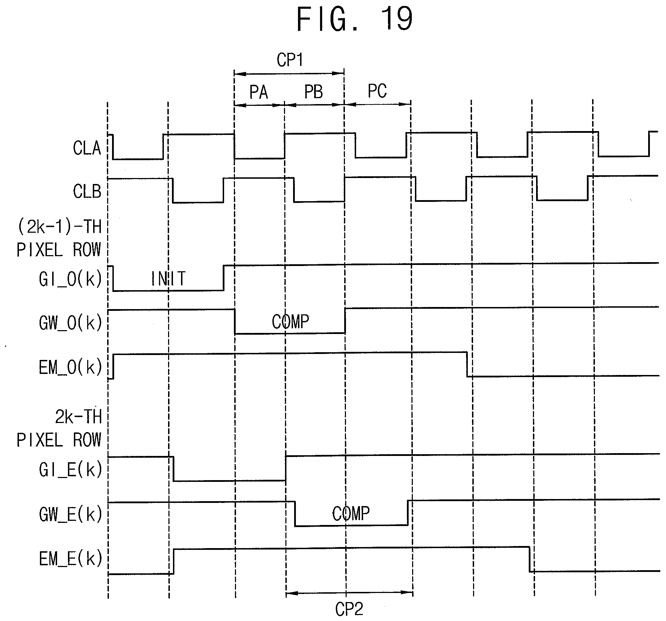

FIG. 17 is a diagram illustrating an example of a display panel included in an organic light emitting display device according to an example not forming part of an embodiment. FIG. 18 is a diagram illustrating an example of a display panel included in the organic light emitting display device of FIG. 17. FIG. 19 is a timing diagram illustrating an example of signals for driving the display panel of FIG. 18.

The organic light emitting display device according to the present example may be driven by an interlace scan method and may drive each pixel row in common. In addition, the organic light emitting display device does not include a data divider having demultiplexers. Except for above features, the organic light emitting display device according to the present example is substantially the same as the organic light emitting display device of FIG. 1. Therefore, the same reference numerals will be used to refer to the same or like parts as those described in the previous embodiment of FIG. 1, and any repetitive explanation concerning the above elements will be omitted.

Referring to FIGS. 17 to 19, the organic light emitting display device may include a display panel 120, a gate driver, a data driver, and a timing controller. The operations of the gate driver, the data driver, and the timing controller are similar or substantially the same as the gate driver, the data driver, and the timing controller of FIG. 1 except for operation timings, and duplicated description will be omitted.

The display panel 120 may be driven by the interlace manner in which odd-numbered pixel rows R1, R3, ... and even-numbered pixel rows R2, R4, ... are driven independently at 1/2 horizontal period intervals.

Odd-numbered pixel rows R1, R3, ... may be connected to odd-numbered initialization lines GI_OL1, GI_OL2, ..., odd-numbered gate lines GW_OL1, GW_OL2, ..., and odd-numbered emission control lines EM_OL1, EM_OL2, .... Even-numbered pixel rows R2, R4, ... may be connected to even-numbered initialization lines GI_EL1, GI_EL2, ..., even-numbered gate lines GW_EL1, GW_EL2, ..., and even-numbered emission control lines EM_EL1, EM_EL2, ....

The odd-numbered data lines DL1, DL3, ... may be connected to the odd-numbered pixel rows R1, R3, ..., respectively. The electrical connection of the odd-numbered data lines DL1, DL3, ... may be controlled based on the first clock signal CLA. The even-numbered data lines DL2, DL4, ... may be connected to the even-numbered pixel rows R2, R4, ..., respectively. The electrical connection of the even-numbered data lines DL2, DL4, ... may be controlled based on the second clock signal CLB.

The initialization period and the emission period are substantially the same as the operations of FIGS. 4, 5, and 15, and duplicated descriptions will be omitted.

As shown in FIG. 19, the compensation period CP1 of the (2k-1)th pixel row may include a first compensation period PA and a second compensation period PB. For example, FIG. 19 shows that the display device is driven by the interlace manner at 120Hz frequency.

During the first compensation period PA, the data line may transfer the data voltage to the driving transistor in the sub-pixel in which the diode-connection is formed such that the threshold voltage of the driving transistor is compensated (i.e., the first compensating operation).

During the second compensation period PB, since the first clock signal CLA is deactivated, the data line may be in a floating status. At this time, the threshold voltage compensating operation may be maintained based on the voltage of the floating data line (i.e., the second compensating operation).

In addition, during the second compensation period PB, since the second clock signal CLB is activated, the sub-pixels of the (2k)th pixel row may perform the data writing and threshold voltage compensating operation (i.e., the first compensating operation)

During the third compensation period PC, the data lines connected to the (2k)th pixel rows may be in floating status, and then the threshold voltage compensating operation may be maintained (i.e., the second compensating operation).

As described above, since the first compensating operation and the second compensating operation are performed during the compensation period in the organic light emitting display device driven by the interlaced manner, the threshold voltage compensation time (e.g., longer than two horizontal periods) may be sufficiently secured under a high-frequency driving environment.

The present inventive concept may be applied to an electronic device having the organic light emitting display device. For example, the present inventive concept may be applied to a head mounted display (HMD) device, a TV, a digital TV, a 3D TV, a personal computer, a home electronic device, a notebook computer, a tablet computer, a mobile phone, a smart phone, a PDA, etc.

The foregoing is illustrative of example embodiments and is not to be construed as limiting thereof. Although a few example embodiments have been described, those skilled in the art will readily appreciate that many modifications are possible in the example embodiments without materially departing from the novel teachings and features of the present inventive concept. Accordingly, all such modifications are intended to be included within the scope of the present inventive concept as defined in the claims. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. An organic light emitting display device (1000) comprising:
a first power source line (ELVDD);
a second power source line (ELVSS);
a display panel including a plurality of pixel groups arranged in pixel rows, each of the pixel groups including a plurality of sub-pixels;
a plurality of initialization lines, wherein each of the plurality of initialization lines is connected to one of the pixel rows;
a first group gate line connected to first pixel groups of the plurality of pixel groups;
a second group gate line connected to second pixel groups of the plurality of pixel groups;
a plurality of emission control lines, wherein each of the plurality of the emission control lines is connected to one of the pixel rows;
a plurality of output lines (CHI-CHi);
data lines (DL1-DLq), wherin the number of data lines is N times greater than the number of output lines and N is an integer greater than or equal to 2;
a data driver (400) and a data divider (500) connected by the plurality of output lines;
a gate driver (200) configured to sequentially provide an initialization signal to the pixel rows via the plurality of initialization lines; to provide a first group gate signal to the first pixel groups of the pixel groups via the first group gate line; to provide a second group gate signal overlapping at least a part of the first group gate signal to second pixel groups of the pixel groups via the second group gate line; to sequentially provide the first group gate signal to the pixel rows, and to sequentially provide the second group gate signal to the pixel rows,
wherein the first group gate line for providing the first group gate signal is solely connected to the first pixel groups,
wherein the second group gate line for providing the second group gate signal is solely connected to the second pixel groups,
wherein the first pixel groups correspond to odd-numbered pixel groups,
wherein the first group gate signal corresponds to an odd-numbered group gate signal,
wherein the second pixel groups correspond to even-numbered pixel groups, and
wherein the second group gate signal corresponds to an even-numbered group gate signal;
wherein each of the sub-pixels included in the first pixel groups includes:
a first transistor (T1) connected between one of the data lines (DL) and a first node (N1), the first transistor including a gate electrode configured to receive the odd-numbered group gate signal (GW_A/B(k)); a driving transistor (TD) connected between the first node and a second node (N2), the driving transistor including a gate electrode connected to a third node (N3); a second transistor (T2) connected between the second node and the third node, the second transistor including a gate electrode configured to receive the odd-numbered group gate signal (GW_A/B(k)); a third transistor (T3) connected between the third node and an initialization power source (VINT), the third transistor including a gate electrode configured to receive the initialization signal (GI(k)); a fourth transistor (T4) connected between the first power source line (ELVDD) and the first node, the fourth transistor including a gate electrode configured to receive the emission control signal (EM(k)); a fifth transistor (T5) connected between the second node and a fourth node (N4), the fifth transistor including a gate electrode configured to receive the emission control signal (EM(k)); a sixth transistor (T6) connected between the initialization power source (VINT) and the fourth node, the sixth transistor including a gate electrode configured to receive the initialization signal (GI(k)); a capacitor (CST) connected between the first power source line (ELVDD) and the third node; and a organic light emitting diode (OLED) connected between the fourth node and a second power source line (ELVSS) configured to provide a voltage lower than a voltage of the first power source line and,
wherein each of the sub-pixels included in the second pixel groups includes: a first transistor connected between one of the data lines and a first node, the first transistor including a gate electrode configured to receive the even-numbered group gate signal; a driving transistor connected between the first node and a second node, the driving transistor including a gate electrode connected to a third node; a second transistor connected between the second node and the third node, the second transistor including a gate electrode configured to receive the even-numbered group gate signal; a third transistor connected between the third node and an initialization power source, the third transistor including a gate electrode configured to receive the initialization signal; a fourth transistor connected between a first power source and the first node, the fourth transistor including a gate electrode configured to receive the emission control signal; a fifth transistor connected between the second node and a fourth node, the fifth transistor including a gate electrode configured to receive the emission control signal; a sixth transistor connected between the initialization power source and the fourth node, the sixth transistor including a gate electrode configured to receive the initialization signal; a capacitor connected between the first power source and the third node; and a organic light emitting diode (OLED) connected between the fourth node and a second power source configured to provide a voltage lower than a voltage of the first power source;
the display device further comprising:
an emission control driver (300) connected to the pixel rows via respective emission control lines of the plurality of emission control lines and configured to sequentially provide an emission control signal to the pixel rows;
wherein the data driver (400) is configured to output the data voltage to the data divider via the plurality of output lines; and
the data divider (500) comprises a plurality of switch transistors, wherein the number of switch transistors equals the number of data lines and each switch transistor is connected between a respective data line and output line, and the switch transistors are configured to receive the data voltages from the data driver via the output lines, wherein the switch transistors are further configured to be controlled by a first clock signal and a second clock signal; wherein the display device is further configured to generate the first clock signal and second clock signal to have an activation phase with a half period difference such that when the first clock signal has an activation level, the data voltages may be provided to the data lines of the odd-numbered pixels and the data voltage may be applied to the sub-pixels of the odd-numbered pixel group, and when the second clock signal is at an activation level, the data voltages are applied to the data lines of the even numbered sub-pixels such that data voltages are applied to the sub-pixels of the even-numbered pixel group, wherein the data divider is configured to selectively provide the data voltage to the data lines connected to each of the plurality of sub-pixels via the switch transistors during a compensation period in which a data writing and threshold voltage compensating operation for the sub-pixels is performed, wherein the compensation period comprises a first compensation period during which a threshold voltage of the driving transistor of a respective one of the sub-pixels is compensated by applying the data voltage to the driving transistor of the respective sub-pixel, and a second compensation period during which the data line of the respective sub-pixel is in a floating state and the operation of compensating the threshold voltage is maintained by the voltage stored in the floating data line and,
wherein a single frame period for each of the pixel rows includes:
an initialization period in which the gate driver is configured to provide an initialization voltage to the third node and the fourth node prior to the compensation period and
an emission period in which each of the pixel rows emits light after the compensation period;
and wherein the gate driver is further configured to turn on the first transistor and the second transistor during the compensation period.

2. An organic light emitting display device according to claim 1, wherein a (k)th even-numbered group gate signal corresponding to a (k)th pixel row is delayed by a 1/2 horizontal period from a (k)th odd-numbered group gate signal corresponding to the (k)th pixel row, where k is an integer greater than 0.

3. An organic light emitting display device according to claim 1, wherein a (k)th odd-numbered group gate signal corresponding to a (k)th pixel row is delayed by a 1/2 horizontal period from a (k)th even-numbered group gate signal corresponding to the (k)th pixel row, where k is an integer greater than 0.

4. An organic light emitting display device according claim 1, wherein a (k)th odd-numbered group gate line for providing a (k)th odd-numbered group gate signal to a (k)th pixel row is disposed farther from the first and second transistors of the sub-pixels included in the (k)th pixel row than a (k)th even-numbered group gate line for providing a (k)th even-numbered group gate signal to the (k)th pixel row, where k is an integer greater than 0,
wherein the (k)th odd-numbered group gate line is connected to the gate electrodes of the first and second transistors included in each of the sub-pixels of the odd-numbered pixel groups by a bridge structure,
wherein a (k+1)th even-numbered group gate line for providing a (k+1)th even-numbered group gate signal to a (k+1)th pixel row is disposed farther from the first and second transistors of the sub-pixels included in the (k+1)th pixel row than a (k+1)th odd-numbered group gate line for providing a (k+1)th odd-numbered group gate signal to the (k+1)th pixel row, and
wherein the (k+1)th even-numbered group gate line is connected to the gate electrodes of the first and second transistors included in each of the sub-pixels of the even-numbered pixel groups by the bridge structure.

5. An organic light emitting display device according to claim 1, wherein a length of an activation period of the first group gate signal and a length of an activation period of the second group gate signal are different from each other.

6. An organic light emitting display device according to any preceding claim, wherein each of the pixel groups includes a first sub-pixel, a second sub-pixel, a third sub-pixel, and a fourth sub-pixel arranged in a first direction in which the pixel rows extend.

7. An organic light emitting display device according to claim 6, wherein a first data line connected to the first sub-pixel and a second data line connected to the second sub-pixel extend in a second direction in which pixel columns extend, the first data line and the second data line disposed between the first sub-pixel and the second sub-pixel,
wherein a third data line connected to the third sub-pixel and a fourth data line connected to the fourth sub-pixel extend in the second direction, the third data line and the fourth data line disposed between the third sub-pixel and the fourth sub-pixel, and
wherein the data lines are not disposed between the second sub-pixel and the third sub-pixel and between the pixel groups.

8. An organic light emitting display device according to claim 1:
wherein the second pixel groups are adjacent to the first pixel groups in the first pixel row, and the gate driver is configured to provide a third group gate signal to third pixel groups in a second pixel row adjacent to the first pixel row, and to provide a fourth group gate signal to fourth pixel groups adjacent to the third pixel groups in the second pixel row;
wherein the emission control driver is configured to provide a first emission control signal to the first pixel row and to provide a second emission control signal to the second pixel row;
and
the data divider is configured to selectively provide the data voltage to the first group data line connected to the first pixel groups, the second group data line connected to the second pixel groups, a third group data line connected to the third pixel groups, and a fourth group data line connected to the fourth pixel groups.

## Patentansprüche

1. Organische lichtemittierende Anzeigevorrichtung (1000), die Folgendes umfasst:
eine erste Stromversorgungsleitung (ELVDD);
eine zweite Stromversorgungsleitung (ELVSS);
ein Anzeigefeld, das eine Vielzahl von Pixelgruppen einschließt, die in Pixelzeilen angeordnet sind, wobei jede der Pixelgruppen eine Vielzahl von Subpixeln einschließt;
eine Vielzahl von Initialisierungsleitungen, wobei jede der Vielzahl von Initialisierungsleitungen mit einer der Pixelzeilen verbunden ist;
eine erste Gruppen-Gate-Leitung, die mit ersten Pixelgruppen der Vielzahl von Pixelgruppen verbunden ist;
eine zweite Gruppen-Gate-Leitung, die mit zweiten Pixelgruppen der Vielzahl von Pixelgruppen verbunden ist;
eine Vielzahl von Emissionssteuerleitungen, wobei jede der Vielzahl der Emissionssteuerleitungen mit einer der Pixelzeilen verbunden ist;
eine Vielzahl von Ausgabeleitungen (CH1-CHi);
Datenleitungen (DL1-DLq), wobei die Anzahl von Datenleitungen N-mal größer ist als die Anzahl von Ausgabeleitungen und N eine ganze Zahl, größer als oder gleich 2, ist;
einen Datentreiber (400) und einen Datenteiler (500), die durch die Vielzahl von Ausgabeleitungen verbunden sind;
einen Gate-Treiber (200), der dafür konfiguriert ist, aufeinanderfolgend ein Initialisierungssignal an die Pixelzeilen über die Vielzahl von Initialisierungsleitungen bereitzustellen; ein erstes Gruppen-Gate-Signal an die ersten Pixelgruppen der Pixelgruppen über die erste Gruppen-Gate-Leitung bereitzustellen; ein zweites Gruppen-Gate-Signal, das mindestens einen Teil des ersten Gruppen-Gate-Signals überlappt, an zweite Pixelgruppen der Pixelgruppen über die zweite Gruppen-Gate-Leitung bereitzustellen, um aufeinanderfolgend das erste Gruppen-Gate-Signal an die Pixelzeilen bereitzustellen und um aufeinanderfolgend das zweite Gruppen-Gate-Signal an die Pixelzeilen bereitzustellen,
wobei die erste Gruppen-Gate-Leitung zum Bereitstellen des ersten Gruppen-Gate-Signals nur mit den ersten Pixelgruppen verbunden ist,
wobei die zweite Gruppen-Gate-Leitung zum Bereitstellen des zweiten Gruppen-Gate-Signals nur mit den zweiten Pixelgruppen verbunden ist,
wobei die ersten Pixelgruppen ungeradzahligen Pixelgruppen entsprechen,
wobei das erste Gruppen-Gate-Signal einem ungeradzahligen Gruppen-Gate-Signal entspricht,
wobei die zweiten Pixelgruppen geradzahligen Pixelgruppen entsprechen, und
wobei das zweite Gruppen-Gate-Signal einem geradzahligen Gruppen-Gate-Signal entspricht,
wobei jedes der in den ersten Pixelgruppen eingeschlossenen Subpixel Folgendes einschließt:
einen ersten Transistor (T1), der zwischen einer der Datenleitungen (DL) und einem ersten Knoten (N1) angeschlossen ist, wobei der erste Transistor eine Gate-Elektrode einschließt, die dafür konfiguriert ist, das ungeradzahlige Gruppen-Gate-Signal (GW_A/B(k)) zu empfangen; einen Ansteuerungstransistor (TD), der zwischen dem ersten Knoten und einem zweiten Knoten (N2) angeschlossen ist, wobei der Ansteuerungstransistor eine Gate-Elektrode einschließt, die mit einem dritten Knoten (N3) verbunden ist; einen zweiten Transistor (T2), der zwischen dem zweiten Knoten und dem dritten Knoten angeschlossen ist, wobei der zweite Transistor eine Gate-Elektrode einschließt, die dafür konfiguriert ist, das ungeradzahlige Gruppen-Gate-Signal (GW_A/B(k)) zu empfangen; einen dritten Transistor (T3), der zwischen dem dritten Knoten und einer Initialisierungsstromversorgung (VINT) angeschlossen ist, wobei der dritte Transistor eine Gate-Elektrode einschließt, die dafür konfiguriert ist, das Initialisierungssignal (GI(k)) zu empfangen; einen vierten Transistor (T4), der zwischen der ersten Stromversorgungsleitung (ELVDD) und dem ersten Knoten angeschlossen ist, wobei der vierte Transistor eine Gate-Elektrode einschließt, die dafür konfiguriert ist, das Emissionssteuersignal (EM(k)) zu empfangen; einen fünften Transistor (T5), der zwischen dem zweiten Knoten und einem vierten Knoten (N4) angeschlossen ist, wobei der fünfte Transistor eine Gate-Elektrode einschließt, die dafür konfiguriert ist, das Emissionssteuersignal (EM(k)) zu empfangen; einen sechsten Transistor (T6), der zwischen der Initialisierungsstromversorgung (VINT) und dem vierten Knoten angeschlossen ist, wobei der sechste Transistor eine Gate-Elektrode einschließt, die dafür konfiguriert ist, das Initialisierungssignal (GI(k)) zu empfangen; einen Kondensator (CST), der zwischen der ersten Stromversorgungsleitung (ELVDD) und dem dritten Knoten angeschlossen ist, und eine organische lichtemittierende Diode (OLED), die zwischen dem vierten Knoten und einer zweiten Stromversorgungsleitung (ELVSS), die dafür konfiguriert ist, eine Spannung, niedriger als eine Spannung der ersten Stromversorgungsleitung, bereitzustellen, angeschlossen ist und,
wobei jedes der in den zweiten Pixelgruppen eingeschlossenen Subpixel Folgendes einschließt: einen ersten Transistor, der zwischen einer der Datenleitungen und einem ersten Knoten angeschlossen ist, wobei der erste Transistor eine Gate-Elektrode einschließt, die dafür konfiguriert ist, das geradzahlige Gruppen-Gate-Signal zu empfangen; einen Ansteuerungstransistor, der zwischen dem ersten Knoten und einem zweiten Knoten angeschlossen ist, wobei der Ansteuerungstransistor eine Gate-Elektrode einschließt, die mit einem dritten Knoten verbunden ist; einen zweiten Transistor, der zwischen dem zweiten Knoten und dem dritten Knoten angeschlossen ist, wobei der zweite Transistor eine Gate-Elektrode einschließt, die dafür konfiguriert ist, das geradzahlige Gruppen-Gate-Signal zu empfangen; einen dritten Transistor, der zwischen dem dritten Knoten und einer Initialisierungsstromversorgung angeschlossen ist, wobei der dritte Transistor eine Gate-Elektrode einschließt, die dafür konfiguriert ist, das Initialisierungssignal zu empfangen; einen vierten Transistor, der zwischen einer ersten Stromversorgung und dem ersten Knoten angeschlossen ist, wobei der vierte Transistor eine Gate-Elektrode einschließt, die dafür konfiguriert ist, das Emissionssteuersignal zu empfangen; einen fünften Transistor, der zwischen dem zweiten Knoten und einem vierten Knoten angeschlossen ist, wobei der fünfte Transistor eine Gate-Elektrode einschließt, die dafür konfiguriert ist, das Emissionssteuersignal zu empfangen; einen sechsten Transistor, der zwischen der Initialisierungsstromversorgung und dem vierten Knoten angeschlossen ist, wobei der sechste Transistor eine Gate-Elektrode einschließt, die dafür konfiguriert ist, das Initialisierungssignal zu empfangen; einen Kondensator, der zwischen der ersten Stromversorgung und dem dritten Knoten angeschlossen ist, und eine organische lichtemittierende Diode (OLED), die zwischen dem vierten Knoten und einer zweiten Stromversorgung, die dafür konfiguriert ist, eine Spannung, niedriger als eine Spannung der ersten Stromversorgung, bereitzustellen, angeschlossen ist;
wobei die Anzeigevorrichtung ferner Folgendes umfasst:
einen Emissionssteuertreiber (300), der über jeweilige Emissionssteuerleitungen der Vielzahl von Emissionssteuerleitungen mit den Pixelzeilen verbunden und dafür konfiguriert ist, aufeinanderfolgend ein Emissionssteuersignal an die Pixelzeilen bereitzustellen,
wobei der Datentreiber (400) dafür konfiguriert ist, die Datenspannung über die Vielzahl von Ausgabeleitungen an den Datenteiler auszugeben; und
der Datenteiler (500) eine Vielzahl von Schalttransistoren umfasst, wobei die Anzahl von Schalttransistoren der Anzahl von Datenleitungen gleicht und jeder Schalttransistor zwischen einer jeweiligen Datenleitung und einer jeweiligen Ausgabeleitung angeschlossen ist, und die Schalttransistoren dafür konfiguriert sind, die Datenspannungen von dem Datentreiber über die Ausgabeleitungen zu empfangen, wobei die Schalttransistoren ferner dafür konfiguriert sind, durch ein erstes Taktsignal und ein zweites Taktsignal gesteuert zu werden; wobei die Anzeigevorrichtung ferner dafür konfiguriert ist, das erste Taktsignal und das zweite Taktsignal so zu erzeugen, dass sie eine Aktivierungsphase mit einer halben Periode Differenz aufweisen, so dass, wenn das erste Taktsignal ein Aktivierungsniveau aufweist, die Datenspannungen an die Datenleitungen der ungeradzahligen Pixel bereitgestellt werden können und die Datenspannung an die Subpixel der ungeradzahligen Pixelgruppe angelegt werden kann, und wenn sich das zweite Taktsignal bei einem Aktivierungsniveau befindet, die Datenspannungen an die Datenleitungen der geradzahligen Subpixel angelegt werden, so dass Datenspannungen an die Subpixel der geradzahligen Pixelgruppe angelegt werden, wobei der Datenteiler dafür konfiguriert ist, während einer Ausgleichsperiode, in der ein Datenschreib- und Schwellenspannungsausgleichsvorgang für die Subpixel durchgeführt wird, selektiv die Datenspannung an die Datenleitungen bereitzustellen, die mit jedem der Vielzahl von Subpixeln über die Schalttransistoren verbunden ist, wobei die Ausgleichsperiode eine erste Ausgleichsperiode, während der eine Schwellenspannung des Ansteuerungstransistors eines jeweiligen der Subpixel durch Anlegen der Datenspannung an den Ansteuerungstransistor des jeweiligen Subpixels ausgeglichen wird, und eine zweite Ausgleichsperiode, während der sich die Datenleitung des jeweiligen Subpixels in einem Schwebezustand befindet und der Vorgang des Ausgleichens der Schwellenspannung durch die in der schwebenden Datenleitung gespeicherte Spannung aufrechterhalten wird und,
wobei eine Einzelbildperiode für jede der Pixelzeilen Folgendes einschließt:
eine Initialisierungsperiode, in welcher der Gate-Treiber dafür konfiguriert ist, vor der Ausgleichsperiode eine Initialisierungsspannung an den dritten Knoten und den vierten Knoten bereitzustellen und
eine Emissionsperiode nach der Ausgleichsperiode, in der jede der Pixelzeilen Licht emittiert,
und wobei der Gate-Treiber ferner dafür konfiguriert ist, den ersten Transistor und den zweiten Transistor während der Ausgleichsperiode anzuschalten.

2. Organische lichtemittierende Anzeigevorrichtung nach Anspruch 1, wobei ein (k)-tes geradzahliges Gruppen-Gate-Signal, das einer (k)-ten Pixelzeile entspricht, um eine 1/2 horizontale Periode gegenüber einem (k)-ten ungeradzahligen Gruppen-Gate-Signal, das der (k)-ten Pixelzeile entspricht, verzögert wird, wobei k eine ganze Zahl, größer als 0, ist.

3. Organische lichtemittierende Anzeigevorrichtung nach Anspruch 1, wobei ein (k)-tes ungeradzahliges Gruppen-Gate-Signal, das einer (k)-ten Pixelzeile entspricht, um eine 1/2 horizontale Periode gegenüber einem (k)-ten geradzahligen Gruppen-Gate-Signal, das der (k)-ten Pixelzeile entspricht, verzögert wird, wobei k eine ganze Zahl, größer als 0, ist.

4. Organische lichtemittierende Anzeigevorrichtung nach Anspruch 1, wobei eine (k)-te ungeradzahlige Gruppen-Gate-Leitung zum Bereitstellen eines (k)-ten ungeradzahligen Gruppen-Gate-Signals an eine (k)-te Pixelzeile weiter von dem ersten und dem zweiten Transistor der in der (k)-ten Pixelzeile eingeschlossenen Subpixel entfernt ist als eine (k)-te geradzahlige Gruppen-Gate-Leitung zum Bereitstellen eines (k)-ten geradzahligen Gruppen-Gate-Signals an die (k)-te Pixelzeile, wobei k eine ganze Zahl, größer als 0, ist,
wobei die (k)-te ungeradzahlige Gruppen-Gate-Leitung durch eine Brückenstruktur mit den Gate-Elektroden des ersten und des zweiten Transistors verbunden ist, die in jedem der Subpixel der ungeradzahligen Pixelgruppen eingeschlossen sind,
wobei eine (k+1)-te geradzahlige Gruppen-Gate-Leitung zum Bereitstellen eines (k+1)-ten geradzahligen Gruppen-Gate-Signals an eine (k+1)-te Pixelzeile weiter von dem ersten und dem zweiten Transistor der in der (k+1)-ten Pixelzeile eingeschlossenen Subpixel entfernt ist als eine (k+1)-te ungeradzahlige Gruppen-Gate-Leitung zum Bereitstellen eines (k+1)-ten ungeradzahligen Gruppen-Gate-Signals an die (k+1)-te Pixelzeile, und
wobei die (k+1)-te geradzahlige Gruppen-Gate-Leitung durch eine Brückenstruktur mit den Gate-Elektroden des ersten und des zweiten Transistors verbunden ist, die in jedem der Subpixel der geradzahligen Pixelgruppen eingeschlossen sind.

5. Organische lichtemittierende Anzeigevorrichtung nach Anspruch 1, wobei sich eine Länge einer Aktivierungsperiode des ersten Gruppen-Gate-Signals und eine Länge einer Aktivierungsperiode des zweiten Gruppen-Gate-Signals voneinander unterscheiden.

6. Organische lichtemittierende Anzeigevorrichtung nach einem der vorhergehenden Ansprüche, wobei jede der Pixelgruppen ein erstes Subpixel, ein zweites Subpixel, ein drittes Subpixel und ein viertes Subpixel einschließt, die in einer ersten Richtung angeordnet sind, in der sich die Pixelzeilen erstrecken.

7. Organische lichtemittierende Anzeigevorrichtung nach Anspruch 6, wobei sich eine erste Datenleitung, die mit dem ersten Subpixel verbunden ist, und eine zweite Datenleitung, die mit dem zweiten Subpixel verbunden ist, in einer zweiten Richtung erstrecken, in der sich Pixelspalten erstrecken, wobei die erste Datenleitung und die zweite Datenleitung zwischen dem ersten Subpixel und dem zweiten Subpixel angeordnet sind,
wobei sich eine dritte Datenleitung, die mit dem dritten Subpixel verbunden ist, und eine vierte Datenleitung, die mit dem vierten Subpixel verbunden ist, in der zweiten Richtung erstrecken, wobei die dritte Datenleitung und die vierte Datenleitung zwischen dem dritten Subpixel und dem vierten Subpixel angeordnet sind, und
wobei die Datenleitungen nicht zwischen dem zweiten Subpixel und dem dritten Subpixel und zwischen den Pixelgruppen angeordnet sind.

8. Organische lichtemittierende Anzeigevorrichtung nach Anspruch 1:
wobei die zweiten Pixelgruppen zu den ersten Pixelgruppen in der ersten Pixelzeile benachbart sind und der Gate-Treiber dafür konfiguriert ist, ein drittes Gruppen-Gate-Signal an dritte Pixelgruppen in einer zu der ersten Pixelzeile benachbarten zweiten Pixelzeile bereitzustellen, und ein viertes Gruppen-Gate-Signal an zu den dritten Pixelgruppen benachbarte vierte Pixelgruppen in der zweiten Pixelzeile bereitzustellen;
wobei der Emissionssteuertreiber dafür konfiguriert ist, ein erstes Emissionssteuersignal an die erste Pixelzeile bereitzustellen und ein zweites Emissionssteuersignal an die zweite Pixelzeile bereitzustellen;
und
der Datenteiler dafür konfiguriert ist, selektiv die Datenspannung an die erste Gruppendatenleitung, die mit den ersten Pixelgruppen verbunden ist, die zweite Gruppendatenleitung, die mit den zweiten Pixelgruppen verbunden ist, eine dritte Gruppendatenleitung, die mit den dritten Pixelgruppen verbunden ist, und eine vierte Gruppendatenleitung, die mit den vierten Pixelgruppen verbunden ist, bereitzustellen.

## Revendications

1. Dispositif d'affichage électroluminescent organique (1000) comprenant :
une première ligne de source d'alimentation (ELVDD) ;
une deuxième ligne de source d'alimentation (ELVSS) ;
un panneau d'affichage incluant une pluralité de groupes de pixels agencés en rangées de pixels, chacun des groupes de pixels incluant une pluralité de sous-pixels ;
une pluralité de lignes d'initialisation, dans lequel chacune de la pluralité de lignes d'initialisation est connectée à l'une des rangées de pixels ;
une première ligne de grille de groupe connectée à des premiers groupes de pixels de la pluralité de groupes de pixels ;
une deuxième ligne de grille de groupe connectée à des deuxièmes groupes de pixels de la pluralité de groupes de pixels ;
une pluralité de lignes de contrôle d'émission, dans lequel chacune de la pluralité de lignes de contrôle d'émission est connectée à une des rangées de pixels ;
une pluralité de lignes de sortie (CH1-Chi) ;
des lignes de données (DL1-DLq), dans lequel le nombre de lignes de données est N fois supérieur au nombre de lignes de sorties et N est un nombre entier supérieur ou égal à 2 ;
un pilote de données (400) et un diviseur de données (500) connectés par la pluralité de lignes de sortie ;
une commande de grille (200) configurée pour fournir séquentiellement un signal d'initialisation aux rangées de pixels *via* la pluralité de lignes d'initialisation ; pour fournir un premier signal de grille de groupe aux premiers groupes de pixels des groupes de pixels *via* la première ligne de grille de groupe ; pour fournir un deuxième signal de grille de groupe recouvrant au moins partiellement le premier signal de grille de groupe à des deuxièmes groupes de pixels des groupes de pixels *via* la deuxième ligne de grille de groupe ; pour fournir séquentiellement le premier signal de grille de groupe aux rangées de pixels, et pour fournir séquentiellement le deuxième signal de grille de groupe aux rangées de pixels,
dans lequel la première ligne de grille de groupe pour fournir le premier signal de grille de groupe est uniquement raccordée aux premiers groupes de pixels,
dans lequel la deuxième ligne de grille de groupe pour fournir le deuxième signal de grille de groupe est uniquement raccordée aux deuxièmes groupes de pixels,
dans lequel les premiers groupes de pixels correspondent à des groupes de pixels en nombre impair,
dans lequel le premier signal de grille de groupe correspond à un signal de grille de groupe en nombre impair,
dans lequel les deuxièmes groupes de pixels correspondent à des groupes de pixels en nombre pair, et
dans lequel le deuxième signal de grille de groupe correspond à un signal de grille de groupe en nombre pair,
dans lequel chacun des sous-pixels inclus dans les premiers groupes de pixels inclut :
un premier transistor (T1) connecté entre une des lignes de données (DL) et un premier noeud (N1), le premier transistor incluant une électrode de grille configurée pour recevoir le signal de grille de groupe en nombre impair (GW_A/B(k)) ; un transistor de commande (TD) connecté entre le premier noeud et un deuxième noeud (N2), le transistor de commande incluant une électrode de grille connectée à un troisième noeud (N3) ; un deuxième transistor (T2) connecté entre le deuxième noeud et le troisième noeud, le deuxième transistor incluant une électrode de grille configurée pour recevoir le signal de grille de groupe en nombre impair (GW_A/B(k)) ; un troisième transistor (T3) connecté entre le troisième noeud et une source d'alimentation d'initialisation (VINT), le troisième transistor incluant une électrode de grille configurée pour recevoir le signal d'initialisation (GI(k)) ; un quatrième transistor (T4) connecté entre la première ligne de source d'alimentation (ELVDD) et le premier noeud, le quatrième transistor incluant une électrode de grille configurée pour recevoir le signal de commande d'émission (EM(k)) ; un cinquième transistor (T5) connecté entre le deuxième noeud et un quatrième noeud (N4), le cinquième transistor incluant une électrode de grille configurée pour recevoir le signal de commande d'émission (EM(k)) ; un sixième transistor (T6) connecté entre la source d'alimentation d'initialisation (VINT) et le quatrième noeud, le sixième transistor incluant une électrode de grille configurée pour recevoir le signal d'initialisation (GI(k)) ; un condensateur (CST) connecté entre la première ligne de source d'alimentation (ELVDD) et le troisième noeud, et une diode électroluminescente organique (OLED) connectée entre le quatrième noeud et une deuxième ligne de source d'alimentation (ELVSS) configurée pour fournir une tension inférieure à une tension de la première ligne de source d'alimentation et,
dans lequel chacun des sous-pixels inclus dans les deuxièmes groupes de pixels inclut : un premier transistor connecté entre une des lignes de données et un premier noeud, le premier transistor incluant une électrode de grille configurée pour recevoir le signal de grille de groupe en nombre pair ; un transistor de commande connecté entre le premier noeud et un deuxième noeud, le transistor de commande incluant une électrode de grille connectée à un troisième noeud ; un deuxième transistor connecté entre le deuxième noeud et le troisième noeud, le deuxième transistor incluant une électrode de grille configurée pour recevoir le signal de grille de groupe en nombre pair ; un troisième transistor connecté entre le troisième noeud et une source d'alimentation d'initialisation, le troisième transistor incluant une électrode de grille configurée pour recevoir le signal d'initialisation ; un quatrième transistor connecté entre une première source d'alimentation et le premier noeud, le quatrième transistor incluant une électrode de grille configurée pour recevoir le signal de commande d'émission ; un cinquième transistor connecté entre le deuxième noeud et un quatrième noeud, le cinquième transistor incluant une électrode de grille configurée pour recevoir le signal de commande d'émission ; un sixième transistor connecté entre la source d'alimentation d'initialisation et le quatrième noeud, le sixième transistor incluant une électrode de grille configurée pour recevoir le signal d'initialisation ; un condensateur connecté entre la première source d'alimentation et le troisième noeud, et une diode électroluminescente organique (OLED) connectée entre le quatrième noeud et une deuxième source d'alimentation configurée pour fournir une tension inférieure à une tension de la première ligne de source d'alimentation ;
le dispositif d'affichage comprenant en outre :
un pilote de commande d'émission (300) connecté aux rangées de pixel *via* des lignes de commande d'émission respectives de la pluralité de lignes de commande d'émission et configuré pour fournir séquentiellement un signal de commande d'émission aux rangées de pixels ;
dans lequel le pilote de données (400) est configuré pour émettre la tension de données au diviseur de données *via* la pluralité de lignes de sortie ; et
le diviseur de données (500) comprend une pluralité de transistors de commutation, dans lequel le nombre de transistors de commutation équivaut au nombre de lignes de données et chaque transistor de commutation est connecté entre une ligne de données et une ligne de sortie respectives, et les transistors de commutation sont configurés pour recevoir les tensions de données du pilote de données *via* les lignes de sortie, dans lequel les transistors de commutation sont en outre configurés pour être commandé par un premier signal d'horloge et un deuxième signal d'horloge ; dans lequel le dispositif d'affichage est en outre configuré pour générer le premier signal d'horloge et le deuxième signal d'horloge de manière à ce qu'ils aient une phase d'activation avec une différence d'une demi-période, de sorte que, lorsque le premier signal d'horloge a un niveau d'activation, les tensions de données peuvent être fournies aux lignes de données des pixels en nombre impair, et la tension de donnée peut être appliquée aux sous-pixels du groupe de pixel en nombre impair, et quand le deuxième signal d'horloge est à un niveau d'activation, les tensions de données sont appliquées aux lignes de données des sous-pixels en nombre pair de sorte que les tensions de données soient appliquées aux sous-pixels du groupe de pixel en nombre pair, dans lequel le diviseur de données est configuré pour fournir sélectivement la tension de données aux lignes de données connectées à chacune de la pluralité de sous-pixels *via* les transistors de commutation pendant une période de compensation dans laquelle une opération d'écriture de données et de compensation de la tension de seuil pour les sous-pixels est réalisée, dans lequel la période de compensation comprend une première période de compensation pendant laquelle une tension de seuil du transistor de commande d'un sous-pixel respectif des sous-pixels est compensée en appliquant la tension de données au transistor de commande du sous-pixel respectif, et une deuxième période de compensation pendant laquelle la ligne de données du sous-pixel respectif est dans un état flottant et l'opération consistant à compenser la tension de seuil est maintenue par la tension stockée dans la ligne de données flottante et,
dans lequel une simple période cadre pour chaque rangée de pixels inclut :
une période d'initialisation dans laquelle la commande de grille est configurée pour fournir une tension d'initialisation au troisième noeud et au quatrième noeud avant la période de compensation et
une période d'émission dans laquelle chacune des rangées de pixel émet de la lumière après la période de compensation ;
et dans lequel la commande de grille est en outre configurée pour allumer le premier transistor et le deuxième transistor pendant la période de compensation.

2. Dispositif d'affichage électroluminescent organique selon la revendication 1, dans lequel un (k)ème signal de grille de groupe en nombre pair correspondant à une (k)ème rangée de pixels est retardé d' 1/2 période horizontale par rapport à un (k)ème signal de grille de groupe en nombre impair correspondant à la (k)ème rangée de pixel, où k est un nombre entier supérieur à 0.

3. Dispositif d'affichage électroluminescent organique selon la revendication 1, dans lequel un (k)ème signal de grille de groupe en nombre impair correspondant à une (k)ème rangée de pixels est retardé d' 1/2 période horizontale par rapport à un (k)ème signal de grille de groupe en nombre pair correspondant à la (k)ème rangée de pixel, où k est un nombre entier supérieur à 0.

4. Dispositif d'affichage électroluminescent organique selon la revendication 1, dans lequel une (k)ème ligne de grille de groupe en nombre impair pour fournir un (k)ème signal de grille de groupe en nombre impair à une (k)ème rangée de pixels est disposée plus loin du premier et du deuxième transistor des sous-pixels inclus dans la (k)ème rangée de pixels qu'une (k)ème ligne de grille de groupe en nombre pair pour fournir un (k)ème signal de grille de groupe en nombre pair à la (k)ème rangée de pixels, dans lequel k est un nombre entier supérieur à 0,
dans lequel la (k)ème ligne de grille de groupe en nombre impair est connectée aux électrodes de grille du premier et du deuxième transistor inclus dans chacun des sous-pixels des groupes de pixel en nombre impair par une structure de pontage,
dans lequel une (k+1)ème ligne de grille de groupe en nombre pair pour fournir un (k+1)ème signal de grille de groupe en nombre pair à une (k+1)ème rangée de pixels est disposée plus loin du premier et du deuxième transistor des sous-pixels inclus dans la (k+1)ème rangée de pixels qu'une (k+1)ème ligne de grille de groupe en nombre impair pour fournir un (k+1)ème signal de grille de groupe en nombre impair à la (k+1)ème rangée de pixels, et
dans lequel la (k+1)ème ligne de grille de groupe en nombre pair est connectée aux électrodes de grille du premier et du deuxième transistor inclus dans chacun des sous-pixels des groupes de pixel en nombre pair par la structure de pontage.

5. Dispositif d'affichage électroluminescent organique selon la revendication 1, dans lequel une longueur d'une période d'activation du premier signal de grille de groupe et une longueur d'une période d'activation du deuxième signal de grille de groupe sont différentes l'une de l'autre.

6. Dispositif d'affichage électroluminescent organique selon l'une quelconque des revendications précédentes, dans lequel chacun des groupes de pixel inclut un premier sous-pixel, un deuxième sous-pixel, un troisième sous-pixel, et un quatrième sous-pixel, agencés dans une première direction dans laquelle s'étendent les rangées de pixels.

7. Dispositif d'affichage électroluminescent organique selon la revendication 6, dans lequel une première ligne de données connectée au premier sous-pixel et une deuxième ligne de données connectée au deuxième sous-pixel s'étendent dans une deuxième direction dans laquelle des colonnes de pixel s'étendent, la première ligne de données et la deuxième ligne de données étant disposées entre le premier sous-pixel et le deuxième sous-pixel,
dans lequel une troisième ligne de données connectée au troisième sous-pixel et une quatrième ligne de données connectée au quatrième sous-pixel s'étendent dans la deuxième direction, la troisième ligne de données et la quatrième ligne de données étant disposées entre le troisième sous-pixel et le quatrième sous-pixel, et
dans lequel les lignes de données ne sont pas disposées entre le deuxième sous-pixel et le troisième sous-pixel et entre les groupes de pixels.

8. Dispositif électroluminescent organique selon la revendication 1 :
dans lequel les deuxièmes groupes de pixels sont adjacents aux premiers groupes de pixels dans la première rangée de pixels, et la commande de grille est configurée pour fournir un troisième signal de grille de groupe à des troisièmes groupes de pixels dans une deuxième rangée de pixels adjacente à la première rangée de pixels et pour fournir un quatrième signal de grille de groupe à des quatrièmes groupes de pixels adjacents aux troisièmes groupes de pixels dans la deuxième rangée de pixels ;
dans lequel le pilote de commande d'émission est configuré pour fournir un premier signal de commande d'émission à la première rangée de pixels et pour fournir un deuxième signal de commande d'émission à la deuxième rangée de pixels ;
et
le diviseur de données est configuré pour fournir sélectivement la tension de données à la première ligne de données de groupe connectée aux premiers groupes de pixels, la deuxième ligne de données de groupe étant connectée aux deuxièmes groupes de pixels, une troisième ligne de données de groupe connectée aux troisièmes groupes de pixels, et une quatrième ligne de données de groupe connectée aux quatrièmes groupes de pixels.
